# EUROPEAN PATENT SPECIFICATION

(11) **EP 2 837 663 B1**
(45) Date of publication and mention of the grant of the patent: **07.10.2015**
(21) Application number: 13180689.5
(22) Date of filing: 16.08.2013
(51) Int. Cl.: C09B 45/48

(54) **Metal complex azo dyes and their use as colorant for color resists**
Metallkomplexazofarbstoffe und deren Verwendung als Färbemittel für Farbschutzschichten
Colorants azoïques de complexe métallique et leur utilisation comme colorant pour des réserves de couleur

(43) Date of publication of application: 18.02.2015
(73) Proprietor: Cheil Industries Inc., Gumi-si Gyeongsangbuk-do 730-030 (KR)
(72) Inventor: Plüg, Carsten, 64367 Mühltal (DE)
(74) Representative: Von Kreisler Selting Werner - Partnerschaft von Patentanwälten und Rechtsanwälten mbB

(56) References cited:
- EP-A1- 0 844 243
- GB-A- 2 065 693
- JP-A- 1 200 989
- JP-A- 62 177 068
- US-A- 2 436 100

## Description

The present invention relates to azo metal complex dyes having improved contrast ratios as well as a method for the production of said dyes. Further, the invention relates to a curable dye composition comprising said azo metal complex dyes, a method for producing the same as well as the use of such compositions for color filters. Further, the present invention relates to a display comprising said azo metal complex dyes.

Liquid crystal displays (LCDs) are used in a wide range of applications, for example computer monitors, televisions, instrument panels, aircraft displays and signage. Especially the use of large screen LCDs has significantly increased. Despite their many advantages LCDs still suffer from several disadvantages, one of them being a rather poor color contrast, especially concerning the color red.

Up to date color filters are important parts in LCDs as they are used for providing colors among the many parts of a liquid crystal display. In order to achieve a high brilliance of color, color filters are employed that remove the long wave length part of the visible spectrum. The existing red color filter formulations employ predominantly C.I. Pigment Red 254 and C.I. Pigment Red 177 as red components for cutting off the long wave length part of the visible spectrum. The position of the absorption bands of these pigments and the resulting color filters can only be altered to a very small extent as the composition of the pigments is given, the color of pigmentary materials is determined by its crystal structure and crystal size, and the requirement of high transparency of color filters requires ultra-fine particles.

The replacement of CCFL (cold cathode fluorescent lambs) by white LED (light-emitting diodes) backlight and, more recently, by the introduction of white OLED (organic light-emitting diodes) backlight lead to the requirement to adjust the position of the color filters in use in order to achieve optimal brightness and transmission of the LCD display.

Most of the color filters used in liquid crystal displays (LCDs) employ photosensitive resin compositions that include a pigment as colorant. Although those pigment-based dyes offer excellent heat stability, the number of suitable pigments is rather limited. Additionally the pigments are only poorly compatible with the polymeric matrices used in color filters. The heterogeneity of those pigment dispersions results in rather poor contrast ratios since the pigment particles reflect, diffract, refract or interfere with light when light is transmitted. In addition, due to the limited number and substitution patterns of suitable pigments adjustment to, for example altered background light, or tuning of color properties of color filters is restricted.

Soluble red dyes have the advantage over red pigments that their color properties can be easily adjusted by altering the substitution on the chromophoric body. However, on adopting dyes from other application fields like disperse dyes, solvent dyes, acid dyes or others, up to now the required performance with respect to stability and optical performance could not be reached. In addition, these dyes have limited solubility and/or insufficient extinction to be applied in color filters.

Accordingly, there is still a need for color filters to increase contrast ratio and brilliancy, particularly in combination with advanced lightning technology.

US 2012/0161087 A1 discloses a photosensitive resin composition for a color filter which includes a yellow dye based on an imidazole chromium complex.

US 2007/0275184 A1 describes an optical film including a visible light absorbing layer which comprises a dye having a maximum absorption wave length in a range of about 470 nm to about 510 nm. The dye may be an anthraquinone dye or perinone dye.

US 2011/0250531 A1 discloses a photosensitive resin composition for a color filter that includes a methine-based dye carrying at least two cyano groups.

US 2,436,100 relates to trifluoroacetylamido-based azo dyes, a process for their preparation as well as textile materials which have been dyed with the mentioned dyes.

US 6,225,023 and US 6,284,877 describe temperature stable, well soluble metal complex dyes from 3-dialkylamino trifluorosulfonilides and related sulfonamide structures.

EP 717403 describes Ni complex azo dyes from 3-dialkylamino acetanilides, alkylsulfonaminides and alkoxycarboylanilines from heterocylic diazonium salts carrying a ring nitrogen atom in alpha position to the azo bridge.

However, there is a substantial need for dyes for color filters that not only provide high contrast ratio, brilliancy and excellent thermal stability but also offer a broad substitution pattern to adjust the properties of the dye, such as absorption range or solubility. In regard to the fast developing field of LCDs, it would furthermore be desirable to be able to quickly and easily adjust the color filters to any arising technical changes, such as background light.

It is therefore an object of the present invention to provide dyes allowing to flexibly adjust the optical properties of red color filter compositions to the individual backlight characteristics of LED and OLED light sources by employing suitable dyes combining high light and process stability, compatibility to existing manufacturing processes, brilliant hue, and high contrast ratio.

It has surprisingly been found that specific azo metal complexes as defined in the present invention demonstrate high thermal stability, at the same time exhibiting a high color contrast.

Therefore, a first embodiment of the present invention is a dye consisting of a metal complex comprising a metal ion M and a deprotonated compound of formula (I): 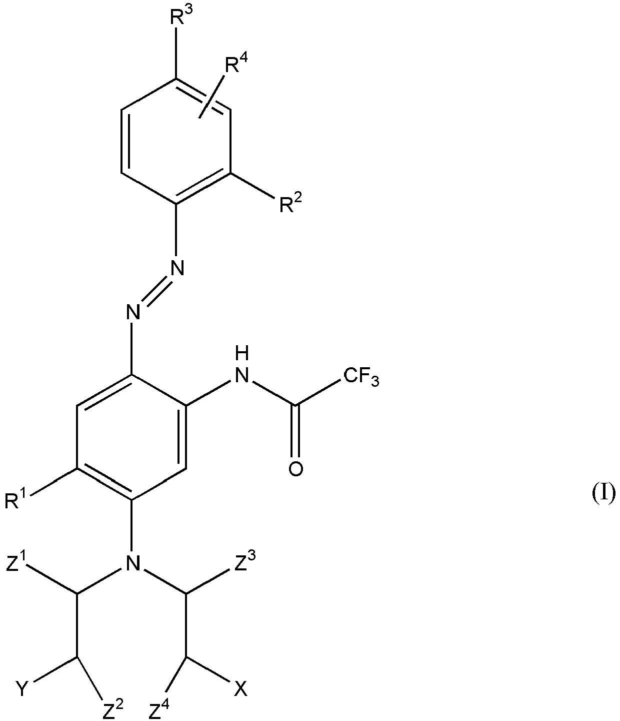 wherein
X is selected from the group consisting of -H, -OH, -OC₁₋₈-alkyl, -C₁₋₅-alkyl, -COOC₁₋₈-alkyl and -OC(O)R⁵;
Y is selected from the group consisting of -H, -OH, -OC₁₋₈-alkyl, -COOC₁₋₈-alkyl, -C₁₋₅-alkyl and -OC(O)R⁵;
Z¹, Z², Z³ and Z⁴ are independently selected from the group consisting of -H, methyl and phenyl;
R¹ is selected from the group consisting of -H, methyl and -OCH₃;
R² is selected from the group consisting of -H, -NO₂, -OC₁₋₈-alkyl, -CF₃, -COOC₁₋₈-alkyl, -CN, -F, -Cl and -Br;
R³ and R⁴ are independently selected from the group consisting of -H, -C₁₋₅-alkyl, -NO₂, -OC₁₋₈-alkyl, -CF₃, -COOC₁₋₈-alkyl, -CN, -F, -Cl and -Br; and
R⁵ is a branched or unbranched saturated carbon chain comprising 1 to 8 carbon atoms.

The substituent -OC₁₋₈-alkyl is preferably selected from the group consisting of -OCH₃, -OCH₂CH₃, -OCH₂CH₂CH₃, -OC₄H₉, -OC₅H₁₁, -OC₆H₁₃, -OC₇H₁₅ and -OC₈H₁₇. The substituent -COOC₁₋₈-alkyl is preferably selected from the group consisting of -COOCH₃, -COOCH₂CH₃, -COOCH₂CH₂CH₃, -COOC₄H₉, -COOC₅H₁₁, -COOC₆H₁₃, -COOC₇H₁₅ and -COOC₈H₁₇.

The substituent -C₁₋₅-alkyl is preferably selected from the group consisting of -CH₃, -CH₂CH₃, -CH₂CH₂CH₃, -C₄H₉ and -C₅H₁₁.

The substituent -OC(O)R⁵ is preferably selected from the group consisting of -OC(O)CH₃, -OC(O)CH₂CH₃, -OC(O)CH₂CH₂CH₃, -OC(O)C₄H₉, -OC(O)C₅H₁₁, -OC(O)C₆H₁₃, -OC(O)C₇H₁₅, -OC(O)C₈H₁₇.

It has been surprisingly found that a complex of a metal ion and a diazo compound which carries a trifluoroacetylamido group exhibits excellent thermal and chemical stability. Additionally, such complexes show a high compatibility with polymeric matrices used in the production of color filters thus leading to an improved homogeneity of the resist composition which in turn leads to high color resolution and color uniformity.

Although it is known to the person skilled in the art that trifluoroacetyl amido diazo dyes can be employed in color filters the compounds suffer from poor light and heat stability. Surprisingly the trifluoroacetylamido diazo dyes showed a vastly improved thermal and chemical stability when employed in the form of a metal complex. Best results can be achieved when a divalent metal ion is used in the complex.

Therefore, an embodiment of the present invention is preferred wherein M is a divalent ion.

In a further preferred embodiment M is selected from the group consisting of copper(II), nickel(II), zinc(II), iron(II) and cobalt(II).

Preferably the metal ion of the complex is chosen in a way as to improve the thermal and chemical stability of the dye. In addition it may be used to adjust the absorption range of the dye as the absorption spectra highly depends on the metal ion used. Complexes having the same ligands but different metal ions may absorb light of different wavelengths.

As is known to the person skilled in the art the chromophore and stability of a complex may differ according to the substitution pattern of the ligand. It has been found that the stability of the dye according to the present invention is much higher when an electron withdrawing substituent is present at the aromatic moiety carrying substituents R², R³ and R⁴.

Electron withdrawing substituents as used in the present invention refer to an atom or a group of atoms which draw part of the electron density of the aromatic ring it is attached to towards itself, thereby causing a shift in the distribution of the electrons, usually by negative mesomeric or inductive effects.

In a preferred embodiment the substituent possess negative mesomeric as well as negative inductive effects.

Therefore, in a preferred embodiment of the present invention R¹ is selected from the group consisting of -H and -OCH₃.

Preferably R² is selected from the group consisting of -H, -NO₂, -OCH₃, -CN and -CF₃.

In a preferred embodiment R³ is selected from the group consisting of -H, -Cl, isopropyl, -CF₃, -NO₂ and -CN.

In a preferred embodiment of the present invention R⁴ is selected from the group consisting of -H, -NO₂ and -CN.

Especially preferred is an embodiment of the present invention wherein
R¹ is selected from the group consisting of -H and -OCH₃;
R² is selected from the group consisting of -H, -NO₂, -OCH₃, -CN and -CF₃;
R³ is selected from the group consisting of -H, -Cl, isopropyl, -CF₃, -NO₂ and -CN; and
R⁴ is selected from the group consisting of -H, -NO₂ and -CN.

Further preferred is an embodiment of the present invention wherein at least one of the substituents R² or R³ is -NO₂ or -CN.

The properties of a metal complex naturally depend on the nature of the metal ion and the ligand as well as the interaction of both. Generally the ligand is bound to the metal ion via a coordinate covalent bond by donating electrons from a lone electron pair into an empty orbital of the metal. In most cases more than one atom of the ligand possesses lone electron pairs and is coordinated to the metal so that the exact nature of the coordination of ligand and metal is difficult to determine and not always clear.

In a preferred embodiment the dye according to the invention is represented by formula (II): 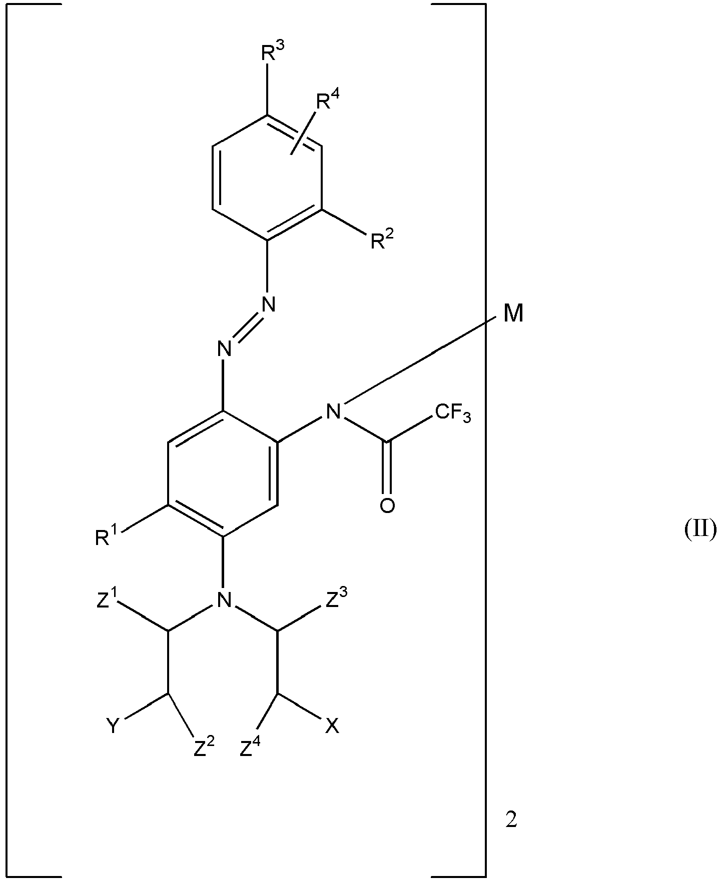 wherein
M is a divalent metal;
X is selected from the group consisting of -H, -OH, -OC₁₋₈-alkyl, -C₁₋₅-alkyl, -COOC₁₋₈-alkyl and -OC(O)R⁵;
Y is selected from the group consisting of -H, -OH, -OC₁₋₈-alkyl, -COOC₁₋₈-alkyl, -C₁₋₅-alkyl and -OC(O)R⁵;
Z¹, Z², Z³ and Z⁴ are independently selected from the group consisting of -H, methyl and phenyl;
R¹ is selected from the group consisting of -H, methyl and -OCH₃;
R² is selected from the group consisting of -H, -NO₂, -OC₁₋₈-alkyl, -CF₃, -COOC₁₋₈-alkyl, -CN, -F, -Cl and -Br;
R³ and R⁴ are independently selected from the group consisting of -H, -C₁₋₅-alkyl, -NO₂, -OC₁₋₈-alkyl, -CF₃, -COOC₁₋₈-alkyl, -CN, -F, -Cl and -Br; and
R⁵ is a branched or unbranched saturated carbon chain comprising 1 to 8 carbon atoms.

In an especially preferred embodiment the metal ion M is selected from the group consisting of copper, nickel, zinc, iron and cobalt.

The substitution pattern of the dye, respectively the substitution pattern of the ligand of the dye, may be used to adjust the properties of the dye. For example the introduction of long alkane chains as substituents to one or more of the aromatic moieties may improve the solubility of the complex in organic solvents.

A color filter usually consists of more than one layer of color resists, usually one layer for each of the colors red, blue and green. Due to subsequent application of the different color resists during the production the process involves several washing steps wherein any uncured resin is removed by washing. Therefore, it is desirable that the dye only possesses a limited solubility in the organic solvents that are used for washing so that the dye will not be flushed out of the cured resin.

Therefore, in order to achieve the desired solubility, an embodiment of the present invention is preferred wherein substituent R¹ is -H.

It has surprisingly been found that the properties of the dye are especially advantageous when the aromatic moiety carries at least one substituent that is not hydrogen and thus may have an influence on the diazo group in a position adjacent to the diazo group.

Thus, an embodiment of the invention is preferred wherein substituent R² is not -H.

Especially preferred is an embodiment wherein R² is selected from the group consisting of -NO₂, -OC₁₋₈-alkyl, -CF₃, -COOC₁₋₈-alkyl, -CN, -Cl, -F and -Br, especially selected from -CN, -CF₃, -Cl and -F.

In a further preferred embodiment of the invention R² and/or R³ are selected from the group consisting of -CN, -NO₂, -COOC₁₋₈-alkyl, preferably selected from -CN and -NO₂.

In a further preferred aspect of the invention R³ and/or R⁴ are selected from the group consisting of -CN, -NO₂, -COOC₁₋₈-alkyl, preferably selected from -CN and -NO₂.

Further, R⁴ is preferably in *ortho* position to R² and R³, i.e. adjacent to R² as well as R³.

The dye according to the present invention offers a variety of different possibilities that allow for adjustments of the properties, one among many being the substituents X and Y. They can be easily introduced and are preferably selected from the group consisting of -H, -OH, -OC₁₋₈-alkyl, -C₁₋₅-alkyl, -COOC₁₋₈-alkyl and -OC(O)R⁵, wherein R⁵ is a branched or unbranched saturated carbon chain comprising 1 to 8 carbons, and wherein X may be different than or the same as Y.

An embodiment of the present invention is preferred wherein X is the same as Y. Preferably X and Y are the same substituent so that the substitution of the nitrogen atom is symmetrical. In an especially preferred embodiment X and Y are both hydrogen.

In a preferred embodiment of the invention the dye is represented by formula (III): 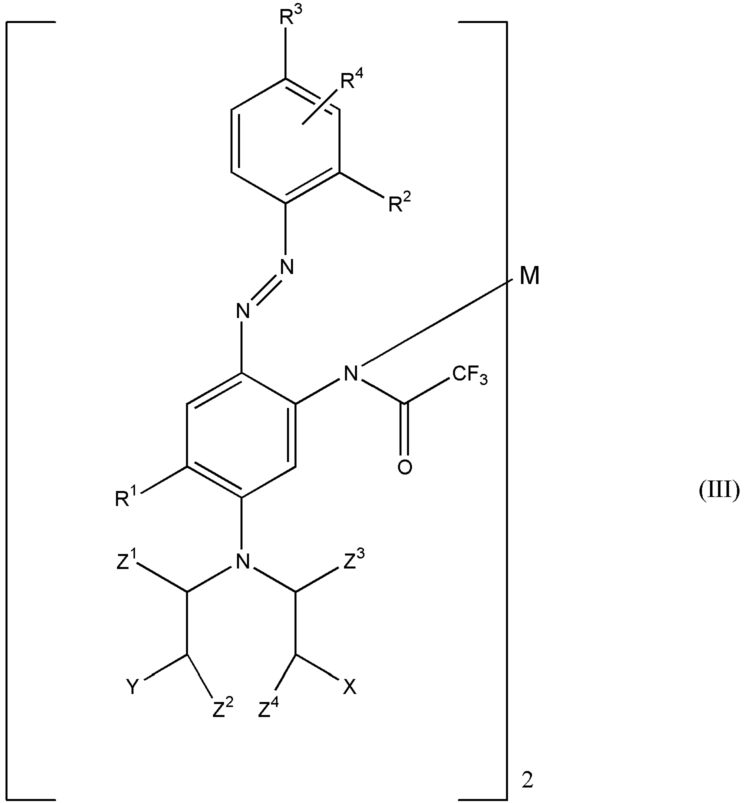 wherein
R¹ = H;
R² = -CN or -NO₂ or -CF₃;
R³ = -CN or -NO₂ or -H or -CF₃, preferably selected from -CN, -NO₂ and -CF₃;
R⁴ = H or -NO₂ or-CN, preferably H;
X = Y and selected from -H, -C₁₋₅-alkyl, -OH, -OC₁₋₈-alkyl, -OC(O)C₁₋₈-alkyl;
M = Fe or Zn or Ni; and
Z¹, Z², Z³ and Z⁴ are independently selected from H, methyl and phenyl with the provisio that
   - if Z¹ is phenyl or methyl than Z² is H;
   - if Z² is phenyl or methyl than Z¹ is H;
   - if Z³ is phenyl or methyl than Z⁴ is H; and
   - if Z⁴ is phenyl or methyl than Z³ is H.

An embodiment of the present invention is especially preferred wherein R¹ and R⁴ are hydrogen, R² is -CF₃, R³ is -NO₂, Z¹, Z², Z³ and Z⁴ are hydrogen, X and Y are hydrogen, and M is Zn.

Further preferred is an embodiment of the present invention wherein R⁴ is in *ortho* position to both R² and R³.

In an especially preferred embodiment R⁴ is in *ortho* position to both R³ and R² and X, Y, Z¹, Z², Z³ and Z⁴ are hydrogen.

In a specially preferred embodiment where R⁴ is in ortho position to both R² and R³ the dye is represented by formula (IIIa): 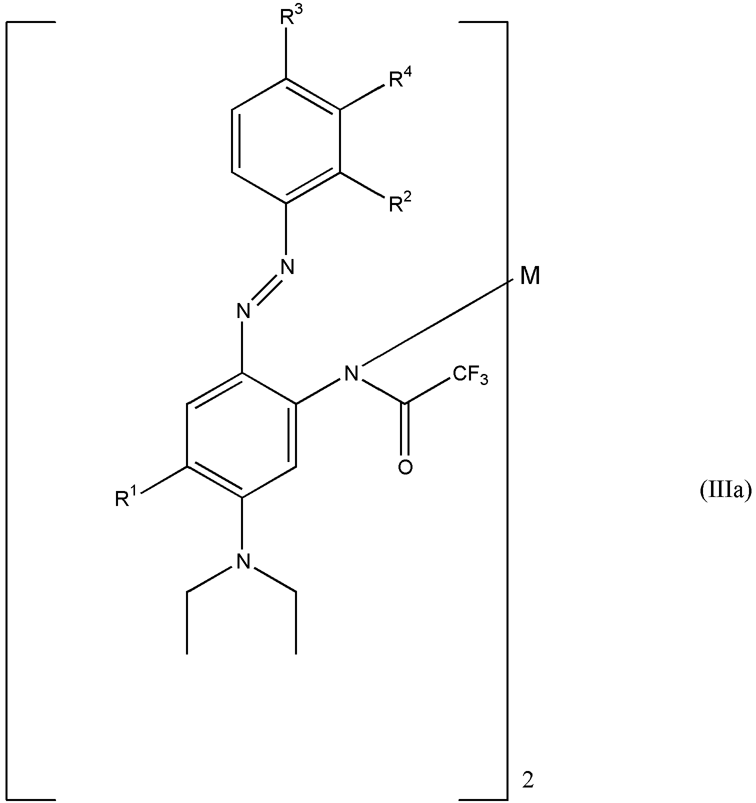 Wherein, preferably
R¹ = H;
R² = -CN or -NO₂ or -CF₃;
R³ = -CN or -NO₂ or -H or -CF₃, preferably selected from -CN, -NO₂ and -CF₃; and
R⁴ = H.

In a preferred embodiment the dye may have a solubility of at least 1 wt.-%, preferably ranging from 2 to 20 wt.-% in an organic solvent which may be used in the curable dye composition, for example in a range from 3 to 12 wt.-% at 20 °C.

Preferably, the solubility of the dye of the present invention at 20 °C is at least 1 wt.-%, preferably 2 to 20 wt.-%, more preferably 3 to 12 wt.-% in at least one of the solvents selected from propylene glycol monomethylether acetate (PGMEA), ethyl 3-ethoxypropionate and cyclohexanone.

The solubility of the dyes of this invention may be measured as describes below.

The dye (about 25 g) is dissolved in 100 g of the respective organic solvent and the solution is agitated for about 5 minutes to obtain a saturated solution at room temperature. 5 ml of the solution at the time when dye precipitation starts to generate is collected, and its weight measured. Then, the solution is dried at about 160 °C for about 2 hours, and the weight of the dye (unit: g) is measured, thereby measuring the solubility of the dye.

Preferably the dye has a maximum absorption wavelength within a wavelength region ranging from 450 to 600 nm, preferably from 500 to 560 nm, and a transmittance ranging from 85 to 100%, preferably from 95 to 100% within a wavelength region ranging from 580 to 800 nm in spectral analysis. When the dye has a maximum absorption wavelength and/or a transmittance within these ranges, it provides high luminance.

Color resists are exposed to elevated temperatures during the production process or later on under operating conditions. Therefore, the dye preferably has high heat resistance. Preferably, the dye according to the invention is thermally decomposed at 200 °C or higher, for example, at a temperature ranging from 250 to 400 °C, measured with a thermogravimetric analyzer (TGA).

Due to the high demands for displays having high color resolution and brilliance there is a constant need for improved color filters with the above mentioned properties.

Therefore, in a preferred embodiment the dye according to the invention is used in color filters.

The dye having the above characteristics can be used in the production of various products including without limitation a color filter such as for a LCD, LED, and the like. Furthermore, the dye according to the invention provides high luminance and can provide a high contrast ratio in a desired color coordinate.

A further embodiment of the invention is a method for preparing a dye according to the invention that involves the following steps:
a) Providing a compound of formula (I) 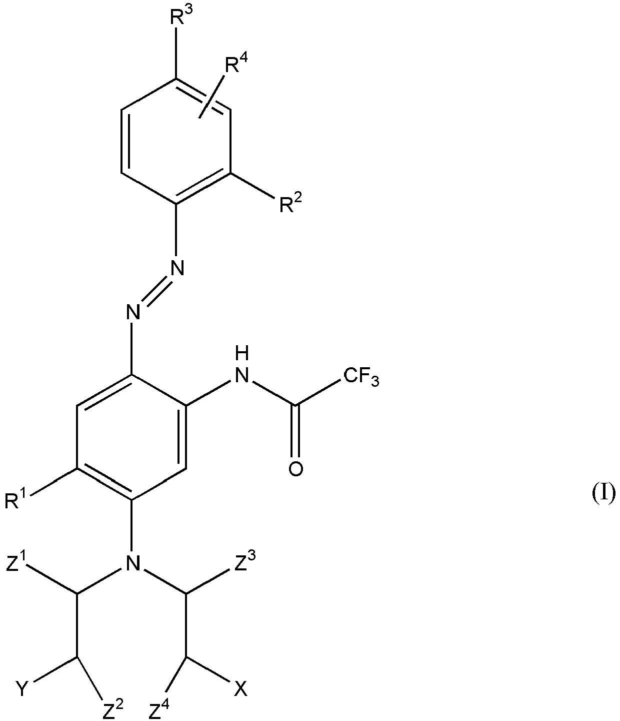 wherein
   X is selected from the group consisting of -H, -OH, -OC₁₋₈-alkyl, -C₁₋₅-alkyl, -COOC₁₋₈-alkyl and -OC(O)R⁵;
   Y is selected from the group consisting of -H, -OH, -OC₁-C₈-alkyl, -COOC₁₋₈-alkyl, -C₁₋₅-alkyl and -OC(O)R⁵;
   Z¹, Z², Z³ and Z⁴ are independently selected from the group consisting of -H, methyl and phenyl;
   R¹ is selected from the group consisting of -H, methyl and -OCH₃;
   R² is selected from the group consisting of -H, -NO₂, -OC₁₋₈-alkyl, -CF₃, -COOC₁₋₈-alkyl, -CN, -F, -Cl and -Br;
   R³ and R⁴ are independently selected from the group consisting of -H, -C₁₋₅-alkyl, -NO₂, -OC₁₋₈-alkyl, -CF₃, -COOC₁₋₈-alkyl, -CN, -F, -Cl and -Br; and
   R⁵ is a branched or unbranched saturated carbon chain comprising 1 to 8 carbon atoms;
b) Deprotonation of the compound of formula (I);
c) Addition of a metal ion M; and
d) Formation of a metal complex consisting of the compound of formula (I) and the metal ion M.

The method for preparing the dye may be carried out in any scale desirable.

The method should be easy to carry out and allow for a safe handling of the components. The method usually does not require any special equipment.

In a preferred embodiment the preparation of the dye according to the invention is carried out in the presence of a solvent, preferably an organic solvent.

Preferably, the solvent is chosen with regard to the solubility of the compound of formula (I) and the other components used for the preparation of the dye. In a preferred embodiment the solvent is chosen in such a way that it might dissolve the compound of formula (I) and the metal ion M and allows isolation of the dye by precipitation after formation or by addition of water, providing a simple method of isolation of the product.

Accordingly, an embodiment is preferred wherein the solvent is selected from the group consisting of N,N-dimethylformamide (DMF), N-methylpyrrolidone (NMP), N,N-dimethylacetamide (DMAc) and dimethylsulfoxide (DMSO).

In order for the metal complex to be formed within a reasonable amount of time the free base of formula (I) is deprotonated. Deprotonation as used herein refers to the abstraction of a proton from an organic molecule. In a preferred embodiment the deprotonation of step b) is hence carried out by a base, preferably a metal alcoholate and/or metal hydride, especially alkali metal alcoholates and/or alkali metal hydrides.

The abstraction of a proton usually requires the presence of a strong base, especially the abstraction of a proton that is attached to a nitrogen atom. Therefore, an embodiment of the invention is preferred wherein the base is selected from the group consisting of sodium hydride, potassium tert-butoxide, sodium tert-butoxide, potassium tert-amyloxide and sodium tert-amyloxide.

Chemical reactions may be carried out at elevated temperatures in order to provide the energy required for the reaction to proceed and to shorten the time until the formation of the complex is complete. On the other hand, the reaction temperature should not be too high as to avoid any thermal decomposition of the reaction components and/or the product, unnecessary waste of resources and undesired side reactions.

Thus, an embodiment of the invention is preferred wherein the formation of step d) is carried out at temperatures above 80 °C, preferably from 90 °C to 180 °C, especially preferred from 100 °C to 150 °C.

In a preferred embodiment the dye is isolated from the reaction mixture by addition of water and subsequently dried. Any residuals may be removed by washing the dye with a suitable washing agent, for example water. Also preferred is an embodiment wherein reaction enhancing compounds, such as a catalyst, may be added when necessary.

In a preferred embodiment the reaction mixture may further contain additives. The additives may be used, for example, to adjust the pH of the reaction mixture or to prevent side reactions by neutralizing side products.

Different colors of, for example a display, are usually generated with the help of color resists that only transmit light of a certain wavelength. The color resists are usually prepared by mixing a dye with a polymeric resin. This mixture is then applied to a matrix and cured by selective exposure to light. In order to be able to mix any desirable color, different layers of different color resists are used, each layer containing a differently colored dye, usually the colors red, blue and green.

The process for applying the mixture may include, for example spin coating, roll coating, Meyer bar coating, doctor blade coating, gravure coating, reverse gravure coating, kiss reverse coating, die coating, or comma coating.

A further embodiment of the invention is a curable dye composition comprising:
i) a dye according to the present invention;
ii) a radically polymerizable compound; and
iii) a photoinitiator.

Usually the dye used in the color resist is the most expensive component since its synthesis is in most cases rather tedious. Therefore, it is desirable to keep the amount of dye needed to achieve the desired effects, such as for example high color brilliance, in the color resist as low as possible in order to save production costs and to preserve resources.

Thus, an embodiment is preferred wherein the dye is present in an amount ranging from 0.1 to 30 wt.-%, preferably from 3.0 to 20 wt.-%, especially preferred 3.0 to 10 wt.-%, based on the total weight of the curable dye composition.

As described above one disadvantage of pigment dyes is that they are indissoluble in the polymeric matrix, leading to reflection, diffraction, refraction or interference with light when light is transmitted. Therefore, it is desirable that the dye may be compatible with the polymeric matrix, thus providing a homogenous color resist.

Therefore, an embodiment is preferred wherein the dye is dissolved in the radically polymerizable compound forming the polymeric matrix.

Further preferred is an embodiment of the invention wherein the radically polymerizable compound is a (meth)acrylate. As used herein, the term "(meth)acrylate" refers to both acrylate and methacrylate when no specific definition is otherwise provided.

Suitable radically polymerizable compounds may include, but are not limited to, ethylene glycol di(meth)acrylate, diethylene glycol di(meth)acrylate, triethylene glycol di(meth)acrylate, propylene glycol di(meth)acrylate, neopentyl glycol di(meth)acrylate, 1,4-butanediol di(meth)acrylate, 1,6-hexanediol di(meth)acrylate, bisphenol A di(meth)acrylate, pentaerythritol di(meth)acrylate, pentaerythritol tri(meth)acrylate, pentaerythritol tetra(meth)acrylte, pentaerythritol hexa(meth)acrylate, dipentaerythritol di(meth)acrylate, dipentaerythritol tri(meth)acrylate, dipentaerythritol penta(meth)acrylate, dipentaerythritol hexa(meth)acrylate, bisphenol A epoxy (meth)acrylate, ethylene glycol monomethylether (meth)acrylate, trimethylol propane tri(meth)acrylate, tris(meth)acryloyloxyethyl phosphate, novolac epoxy (meth)acrylate or combinations thereof.

Polymerizable compound as used herein refers to monomeric and/or oligomeric compounds as well as mixtures thereof. Further, polymerizable compounds can be acrylic based resins.

In a preferred embodiment the radically polymerizable compound is present in an amount of 1 to 40 wt.-%, preferably 1.5 to 30 wt.-%, based on the total weight of the curable dye composition.

In a preferred embodiment the radically polymerizable compound is an acrylic-based binder resin. The acrylic-based binder resin is preferably a copolymer of a first ethylenic unsaturated monomer and a second ethylenic unsaturated monomer that is copolymerizable with the first ethylenic unsaturated monomer, and a resin including at least one acrylic-based repeating unit.

The first ethylenic unsaturated monomer is preferably an ethylenic unsaturated monomer including at least one carboxyl group. Examples of the first ethylenic unsaturated monomer including at least one carboxyl group include without limitation acrylic acid, methacrylic acid, maleic acid, itaconic acid, fumaric acid, and the like, and combinations thereof.

The acrylic-based resin may comprise the first ethylenic unsaturated monomer in an amount ranging from 5 to 50 wt %, for example, from 10 to 40 wt %, based on the total weight of the acrylic-based binder resin. Further, according to some embodiments of the present invention, the amount of the first ethylenic unsaturated monomer can be in a range from any of the foregoing amounts to any other of the foregoing amounts.

The second ethylenic unsaturated monomer may comprise, without limitation, aromatic vinyl compounds such as styrene, α-methylstyrene, vinyltoluene, vinylbenzylmethylether, and the like; unsaturated carboxylic acid ester compounds such as methyl(meth)acrylate, ethyl(meth)acrylate, butyl(meth)acrylate, 2-hydroxyethyl(meth)acrylate, 2-hydroxy butyl(meth)acrylate, benzyl(meth)acrylate, cyclohexyl(meth)acrylate, phenyl(meth)acrylate, and the like; unsaturated carboxylic acid amino alkyl ester compounds such as 2-aminoethyl(meth)acrylate, 2-dimethylaminoethyl(meth)acrylate, and the like; carboxylic acid vinyl ester compounds such as vinyl acetate, vinyl benzoate, and the like; unsaturated carboxylic acid glycidyl ester compounds such as glycidyl(meth)acrylate and the like; vinyl cyanide compounds such as (meth)acrylonitrile and the like; unsaturated amide compounds such as (meth)acrylamide and the like; and the like. The second ethylenic unsaturated monomer may be used singularly or as a mixture of two or more ethylenic unsaturated monomers.

Examples of the acrylic-based binder resin may include without limitation a methacrylic acid/benzylmethacrylate copolymer, a methacrylic acid/benzylmethacrylate/styrene copolymer, a methacrylic acid/benzylmethacrylate/2-hydroxyethylmethacrylate copolymer, a methacrylic acid/benzylmethacrylate/styrene/2-hydroxyethylmethacrylate copolymer, and the like. The acrylic-based binder resin may be used singularly or as a mixture of two or more acrylic-based binder resins.

The acrylic-based binder resin may have a weight average molecular weight ranging from 3000 to 150,000, preferably from 5000 to 50,000, for example, from 20,000 to 30,000. When the acrylic-based binder resin has a weight average molecular weight within these ranges, the composition has excellent close contacting (adhesive) properties with a substrate, good physical and chemical properties, and appropriate viscosity.

The acrylic-based binder resin may have an acid value ranging from 15 to 60 mg KOH/g, for example from 20 to 50 mg KOH/g. When the acrylic-based binder resin has an acid value within these ranges, it brings about excellent pixel resolution.

In a preferred embodiment, the curable dye composition may comprise the acrylic-based binder resin in an amount ranging from 1 to 30 wt %, for example, from 5 to 20 wt %, based on the total weight of the curable dye composition. In some embodiments, the curable dye composition may include the acrylic-based binder resin in an amount from at least 1 up to 30 wt.-% and with increasing preference in the order given of at least 2, at least 3, at least 4, at least 5, at least 6, at least 7, at least 8, at least 9, at least 10, at least 11, at least 12, at least 13, at least 14, at least 15, at least 16, at least 17, at least 18, at least 19, at least 20, at least 21, at least 22, at least 23, at least 24, at least 25, at least 26, at least 27, at least 28 and at least 29 wt.-%, based on the total weight of the curable dye composition. Further acrylic-based binder resin may be present in an amount of up to 30 wt.-% to at least 1 wt.-% and with increasing preference in the order given of up to 29, up to 28, up to 27, up to 26, up to 25, up to 24, up to 23, up to 22, up to 21, up to 20, up to 19, up to 18, up to 17, up to 16, up to 15, up to 14, up to 13, up to 12, up to 11, up to 10, up to 9, up to 8, up to 7, up to 6, up to 5, up to 4, up to 3 and up to 2 wt.-%, based on the total weight of the curable dye composition. Further, according to some embodiments of the present invention, the amount of the acrylic-based binder resin can be in a range from any of the foregoing amounts to any other of the foregoing amounts.

When the acrylic-based binder resin is included in an amount within these ranges, it was found that the composition has excellent developing properties and improved cross-linking, and thus has excellent surface flatness when fabricated into a color filter.

In an alternatively preferred embodiment the radically polymerizable compound may include a multi-functional monomer having two or more hydroxyl groups. Examples of the radically polymerizable compound may include without limitation glycerol acrylate, dipentaerythritol hexaacrylate, ethylene glycol diacrylate, triethylene glycol diacrylate, 1,4-butanedioldiacrylate, 1,6-hexanediol diacrylate, neopentyl glycol diacrylate, pentaerythritol diacrylate, pentaerythritol triacrylate, pentaerythritol diacrylate, dipentaerythritol triacrylate, dipentaerythritol acrylate, pentaerythritol hexaacrylate, bisphenol A diacrylate, trimethylol propane triacrylate, novolacepoxy acrylate, ethylene glycol dimethacrylate, diethylene glycol dimethacrylate, triethylene glycol dimethacrylate, propylene glycol dimethacrylate, 1,4-butanediol dimethacrylate, 1,6-hexanediol dimethacrylate, and the like, and combinations thereof.

In a further preferred embodiment the radically polymerizable compound may be present in an amount up to 30 wt.-%, such as ranging from 1 to 15 wt.-%, preferably from 5 to 10 wt.-%, based on the total weight of the curable dye composition. In some embodiments, the curable dye composition may comprise the radically polymerizable compound in an amount from at least 1 to up to 15 wt.-% and with increasing preference in the order given of at least 2, at least 3, at least 4, at least 5, at least 6, at least 7, at least 8, at least 9, at least 10, at least 11, at least 12, at least 13 and at least 14 wt.-%. Further, the radically polymerizable compound may be present in the curable dye composition in an amount of up to 15 to at least 1 wt.-% and with increasing preference in the order given of up to 14, up to 13, up to 12, up to 11, up to 10, up to 9, up to 8, up to 7, up to 6, up to 5, up to 4, up to 3 and up to 2 wt.-%, based on the total weight of the curable dye composition, respectively.

In a further preferred embodiment the curable dye composition may comprise more than one polymerizable compound which are different from each other.

It was found, that the composition exhibits excellent pattern characteristics and developing properties, when the radically polymerizable compound was present in the above mentioned amounts.

The curable dye composition according to the invention further comprises a photoinitiator.

The photoinitiator may be any photopolymerization initiator known in the art for preparing photosensive resin compositions for color filter. Exemplary photoinitiators may include without limitation acetophenone-based compounds, benzophenone-based compounds, thioxanthone-based compounds, benzoin-based compounds, triazine-based compounds, oxime-based compounds and the like and combinations thereof.

Exemplary acetophenone-based compounds may include without limitation 2,2'-diethoxyacetophenone, 2,2'-dibutoxyacetophenone, 2-hydroxy-methylpropioacetophenone, p-t-butyltrichloroacetophenone, p-t-butyldichloroacetophenone, 4-chloroacetophenone, 2,2'-dichloro-4-phenoxyacetophenone, 2-methyl-1-(4-methylthio)phenyl)-2-morpholinopropane-1-one, 2-benzyl-2-dimethylamino-1-(4-morpholinophenyl)-butane-1-one and the like as well as combinations thereof.

Exemplary benzophenone-based compounds may include without limitation benzophenone, benzoyl benzoic acid, benzoyl benzoic acid methyl, 4-phenyl benzophenone, hydroxyl benzophenone, acrylic benzophenone, 4,4'-bis(dimethyl amino)benzophenone, 4,4'-bis(diethylamino)benzophenone, 4,4'-dimethylaminobenzophenone, 4,4'-dichlorobenzophenone, 3,3'-dimethyl-2-methoxybenzophenone, and the like and combinations thereof.

Exemplary thioxanthone-based compounds may include without limitation thioxanthone, 2-methylthioxanthone, isopropyl thioxanthone, 2,4-diethyl thioxanthone, 2,4-diisopropyl thioxanthone, 2-chlorothioxanthone, and the like as well as combinations thereof.

Exemplary benzoin-based compounds may include without limitation benzoin, benzoin methyl ether, benzoin isobutyl ether, benzoin ethyl ether, benzoin isopropyl ether, benzyldimethylketal, and the like, as well as combinations thereof.

Exemplary triazine-based compounds max include without limitation 2,4,6-trichloro-s-triazine, 2-phenyl 4,6-bis(trichloromethyl)-s-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-biphenyl 4,6-bis(trichloromethyl)-s-tiazine, bis(trichloromethyl)-6-styryl-s-triazine, 2-(naphtha-1-yl)-4,6-bis(trichloromethyl)triazine, 2-(4-methoxynaphtha-1-yl)-4,6-bis(trichloromethyl)triazine, 2-4-trichloromethyl(piperonyl)-6-triazine, 2-4-trichloromethyl (4'-methoxystyryl)-6-triazine, and the like, and combination thereof.

Exemplary oxime-based compounds may include without limitation 2-(*o-*benzoyloxime)-1-[4-(phenylthio)phenyl]-1,2-octanedione, 1-(*o*-acetyloxime)-1-[9-ethyl-6-(2-methylbenzoyl)-9H-carbazole-3-yl]ethanone, and the like and combinations thereof.

Exemplary photoinitiators may also include carbazole-based compounds, diketone-based compounds, sulfonium borate-based compounds, nonimidazole-based compounds, and the like, and combinations thereof, in addition to or as an alternative to the aforementioned photoinitiators.

In a preferred embodiment the photoinitiator is present in amount ranging from 0.1 to 10 wt.-%, based on the total weight of the curable dye composition. In an especially preferred embodiment the photoinitiator is present in an amount ranging from 0.5 to 5 wt.-%, based on the total weight of the curable dye composition.

When the photoinitiator is present in an amount within these ranges, the composition can be sufficiently photopolymerized when exposed to light during the pattern-forming process for preparing a color filter, and also exhibits excellent sensitivity and improved transmittance.

In a preferred embodiment the curable dye composition further comprises a solvent.

The solvent is not specifically limited. Examples of the solvent include without limitation alcohols such as methanol, ethanol, and the like; ethers such as dichloroethyl ether, n-butyl ether, diisoamyl ether, methylphenyl ether, tetrahydrofuran, and the like; glycol ethers such as ethylene, glycol monomethylether, ethylene glycol monoethylether, and the like; cellosolve acetates such as methyl cellosolve acetate, ethyl cellosolve acetate, diethyl cellosolve acetate, and the like; carbitols such as methylethyl carbitol, diethyl carbitol, diethylene glycol monomethylether, diethylene glycol monoethylether, diethylene glycol dimethylether, diethylene glycol methylethylether, diethylene glycol diethylether, and the like; propylene glycol alkylether acetates such as propylene glycol methylethyl acetate, propylene glycol methylether acetate, propylene glycol propylether acetate, and the like; aromatic hydrocarbons such as toluene, xylene, and the like; ketones such as methylethylketone, cyclohexanone, 4-hydroxy-4-methyl-2-pentanone, methyl-n-propylketone, methyl-n-butylketone, methyl-n-amylketone, 2-heptanone, and the like; saturated aliphatic monocarboxylic acid alkyl esters such as ethyl acetate, n-butyl acetate, isobutyl acetate, and the like; lactic acid alkyl esters such as methyl lactate, ethyl lactate, and the like; hydroxyacetic acid alkyl esters such as methyl hydroxyacetate, ethyl hydroxyacetate, butyl hydroxyacetate, and the like; acetic acid alkoxyalkyl esters such as methoxymethyl acetate, methoxyethyl acetate, methoxybutyl acetate, ethoxymethyl acetate, ethoxyethyl acetate, and the like; 3-hydroxypropionic acid alkyl esters such as methyl 3-hydroxypropionate, ethyl 3-hydroxypropionate, and the like; 3-alkoxypropionic acid alkyl esters such as methyl 3-methoxypropionate, ethyl 3-methoxypropionate, ethyl 3-ethoxypropionate, methyl 3-ethoxypropionate, and the like; 2-hydroxypropionic acid alkyl esters such as methyl 2-hydroxypropionate, ethyl 2-hydroxypropionate, propyl 2-hydroxypropionate, and the like; 2-alkoxypropionic acid alkyl esters such as methyl 2-methoxypropionate, ethyl 2-methoxypropionate, ethyl 2-ethoxypropionate, methyl 2-ethoxypropionate, and the like; 2-oxy-2-methylpropionic acid alkyl esters such as methyl 2-hydroxy-2-methylpropionate, ethyl 2-hydroxy-2-methylpropionate, and the like; 2-alkoxy-2-methylpropionic acid alkyl esters such as methyl 2-methoxy-2-methylpropionate, ethyl 2-ethoxy-2-methylpropionate, and the like; esters such as 2-hydroxyethyl propionate, 2-hydroxy-2-methylethyl propionate, hydroxyethyl acetate, methyl 2-hydroxy-3-methylbutanoate; ketonic acid esters such as ethyl pyruvate; and the like, and combinations thereof. Furthermore, the solvent may be N-methylformamide, N,N-dimethyl formamide, N-methylformanilide, N-methylacetamide, N,N-dimethyl acetamide, N-methylpyrrolidone, dimethylsulfoxide, benzylethylether, dihexylether, acetyl acetone, isophorone, caproic acid, caprylic acid, 1-octanol, 1-nonanol, benzyl alcohol, benzyl acetate, ethyl benzoate, diethyl oxalate, diethyl maleate, [gamma]-butyrolactone, ethylene carbonate, propylene carbonate, phenyl cellosolve acetate, and the like. These solvents may be used singularly or in a combination.

In exemplary embodiments, taking into account factors such as miscibility, reactivity, and the like, examples of the solvent may include without limitation glycol ethers such as ethylene glycol monoethyl ether and the like; ethylene glycol alkylether acetates such as ethyl cellosolve acetate and the like; esters such as 2-hydroxyethyl propionate and the like; diethylene glycols such as diethylene glycol monomethyl ether and the like; propylene glycol alkylether acetates such as propylene glycol monomethylether acetate, propylene glycol propylether acetate, and the like; and combinations thereof.

The solvent may be present in a balance amount, for example, in an amount ranging from 20 to 90 wt.-%, based on the total weight of the curable dye composition. In some embodiments, the curable dye composition may comprise the solvent in an amount of at least 20 and up to 90 wt.-% and with increasing preference in the order given of at least 21, at least 22, at least 23, at least 24, at least 25, at least 26, at least 27, at least 28, at least 29, at least 30, at least 31, at least 32, at least 33, at least 34, at least 35, at least 36, at least 37, at least 38, at least 39, at least 40, at least 41, at least 42, at least 43, at least 44, at least 45, at least 46, at least 47, at least 48, at least 49, at least 50, at least 51, at least 52, at least 53, at least 54, at least 55, at least 56, at least 57, at least 58, at least 59, at least 60, at least 61, at least 62, at least 63, at least 64, at least 65, at least 66, at least 67, at least 68, at least 69, at least 70, at least 71, at least 72, at least 73, at least 74, at least 75, at least 76, at least 77, at least 78, at least 79, at least 80, at least 81, at least 82, at least 83, at least 84, at least 85, at least 86, at least 87, at least 88 and at least 89 wt.-%, based on the total weight of the curable dye composition, respectively. Further, the curable dye composition may comprise the solvent in an amount of up to 90 to at least 20 wt.-% and with increasing preference in the order given of up to 89, up to 88, up to 87, up to 86, up to 85, up to 84, up to 83, up to 82, up to 81, up to 80, up to 79, up to 78, up to 77, up to 76, up to 75, up to 74, up to 73, up to 72, up to 71, up to 70, up to 69, up to 68, up to 67, up to 66, up to 65, up to 64, up to 63, up to 62, up to 61, up to 60, up to 59, up to 58, up to 57, up to 56, up to 55, up to 54, up to 53, up to 52, up to 51, up to 50, up to 49, up to 48, up to 47, up to 46, up to 45, up to 44, up to 43, up to 42, up to 41, up to 40, up to 39, up to 38, up to 37, up to 36, up to 35, up to 34, up to 33, up to 32, up to 31, up to 30, up to 29, up to 28, up to 27, up to 26, up to 25, up to 24, up to 23, up to 22 and up to 21 wt.-%, based on the total weight of the curable dye composition, respectively. Further, according to some embodiments of the present invention, the amount of the solvent can be in a range from any of the foregoing amounts to any other of the foregoing amounts.

It was found that, when the solvent was present in an amount within these ranges, the curable dye composition had excellent coating properties and maintained excellent flatness in a layer having a thickness of 3 µm or more.

The curable dye composition according to the invention may further comprise a surfactant to uniformly disperse the dye into the solvent and to improve leveling performance.

The surfactant may be fluorine-based.

The fluorine-based surfactant may have a weight average molecular weight ranging from 4000 to 10,000, for example, from 6000 to 10,000. In addition, the fluorine-based surfactant may have surface tension ranging from 18 to 23 mN/m (measured in a 0.1% polyethylene glycol methylether acrylate (PEGMEA) solution). When the fluorine-based surfactant has a weight average molecular weight and surface tension within these ranges, the composition shows improved leveling performance and an excellent stain characteristic during high speed coating. In addition, the composition generates less vapor and less defects in a layer, so that the composition is suitable for high speed coating methods, for example slit coating methods.

Examples of the fluorine-based surfactant may include without limitation F-482, F-484, F-478, and the like, and combinations thereof, which are commercially available from DIC Co., Ltd.

Other exemplary surfactants may include silicon-based surfactants, in addition to or as an alternative to the fluorine-based surfactant.

Examples of the silicon-based surfactant may include without limitation TSF400, TSF401, TSF410, TSF4440, and the like, and combinations thereof, which are commercially available from Toshiba Silicon Co., Ltd.

The curable dye composition may include the surfactant in an amount ranging from 0.01 to 5 wt.-%, for example, from 0.1 to 2 wt.-%, based on the total weight of the curable dye composition. When the surfactant is included in an amount within these ranges, the composition shows fewer impurities generated after development.

The curable dye composition may further include other additives such as but not limited to malonic acid, 3-amino-1,2-propanediol, and/or a vinyl- or (meth)acryloxy-containing silane-based coupling agent, in order to prevent stains or spots during the coating, to adjust leveling, or to prevent pattern residue due to non-development. These additives may be added in conventional amounts, which can be readily selected by the skilled artisan based on desired properties.

In addition, the curable dye composition may additionally include an epoxy compound to improve the close contacting (adhesive) properties and other characteristics if needed.

Exemplary epoxy compounds may include without limitation epoxy novolac acryl carboxylate resins, ortho cresol novolac epoxy resins, phenol novolac epoxy resins, tetra methyl biphenyl epoxy resins, bisphenol A-type epoxy resins, alicyclic epoxy resins, and the like, and combinations thereof.

For cases where the epoxy compound is present in the curable dye composition, a peroxide initiator or a radical polymerization initiator such as an azobis-based initiator can additionally be present in the curable dye composition.

The curable dye composition may include the epoxy compound in an amount of 0.01 to 5 wt.-%, based on the total weight of the curable dye composition. When the epoxy compound is included in an amount ranging from 0.01 to 5 wt.-%, it can improve storage, close contacting (adhesion), and other properties.

In a preferred embodiment an antioxidant and/or a UV light absorbent additive may be added to increase the durability of the curable dye composition.

In a preferred embodiment the curable dye composition may comprise the following components:
i) 0.1 to 30 wt.-% of a dye according to the invention;
ii) 1.0 to 40 wt.-% of a radically polymerizable compound;
iii) 0.1 to 10 wt.-% of a photoinitiator;
iv) optionally 0.01 to 5 wt.-% of a surfactant;
v) optionally 0.01 to 5 wt.-% of an epoxy compound;
vi) optionally 0.1 to 5 wt.-% of further additives other than those mentioned under iv) and v); and
vii) optionally a solvent, preferably in an amount to balance the curable dye composition to 100 wt.-%.

The curable dye composition according to the invention has excellent heat resistance and durability, high absorption in a wavelength region ranging from 400 to up to 620 nm, high luminance, and high contrast ratio, and thus can be used to provide a color filter that has improved pattern characteristics, development processibility, chemical resistance, color reproducibility, and the like.

According to a preferred embodiment the curable dye composition can be prepared by mixing the following components:
(i) dye according to the invention in an amount ranging from 0.1 to 20 wt.-%;
(ii-1) the acrylic-based binder resin in an amount up to 30 wt.-%, preferably ranging from 1 to 30 wt.-%;
(ii-2) optionally a radically polymerizable compound which is different from resin (ii-1) in an amount up to 15 wt.-%, preferably ranging from 1 to 15 wt.-%;
(iii) the photoinitiator in an amount ranging from 0.1 to 10 wt.-%; and
(vii) the solvent, preferably in an amount balancing the composition to 100 wt.-%.

After the curable dye composition is applied to a surface, for example glass that serves as base of the color filter, the curable dye composition is preferably cured by the selective exposure to light, for example by employment of a laser. The cured dye composition is preferably in the form of a film and serves as one colored layer, preferably as the red layer, of the color filter.

Therefore, a further embodiment of the present invention is a cured dye composition obtainable by curing a curable dye composition according to the invention. The curing is preferably a photocuring.

As the person skilled in the art may know, the time of the curing process as well as the energy and wavelength of the light source, for example the laser, vary depending on the nature of the dye, the nature of the radically polymerizable compound as well as on the photoinitiator used. Preferably energy and wavelength are chosen in a way that the curable dye composition can be thoroughly cured without causing any damage to the dye present. Preferably the curing is conducted in a way that the cured dye composition shows a proper adhesion to the surface.

There is no particular limitation regarding the method used to prepare the curable dye composition. The curable dye composition can be prepared by mixing the dye according to the invention, the radically polymerizable compound, the photoinitiator, and optionally any of the above mentioned compounds and/or additives.

The color filter may be fabricated using any suitable conventional method. For example, the color filter may be prepared using spin-coating, roller-coating, slit-coating, and the like to form a layer of the composition on a suitable substrate, the layer having a thickness ranging from 1.5 to 3.0 µm. After coating the composition to form a layer, the layer is exposed to radiation, such as UV radiation, electron beam, or X-ray to form a pattern required for a color filter. The UV radiation may have a wavelength region ranging from 190 to 450 nm, for example, from 200 to 400 nm. Next, the coated layer is treated with an alkali developing solution, and the unradiated (non-exposed) region thereof may be dissolved, forming a pattern for an image color filter. This process can be repeated as necessary to form the desired number of red, green, and blue colors, to fabricate a color filter having a desired pattern. In addition, the image pattern acquired by the development step can be cured through heat treatment, actinic ray radiation, or the like, which can improve crack resistance, solvent resistance, and the like.

The application of color filters is not limited to LC-displays. They can also be found in cameras and other optical devices. Thus, a further embodiment of the present invention is the use of a dye according to the invention or a curable dye composition according to the invention or a cured dye composition according to the invention for color filters.

In LC-displays the light source, namely the background light, is usually present in the form of a foil that comprises OLEDs which provide white light (W-OLED). Since the spectral range of white light emitted by an OLED slightly differs from that of a conventional light source, the dyes used in color filters have to be adjusted to achieve high contrast and color brilliance. Therefore, it is desirable to have dyes the absorption range of which can be easily modified, for example by manipulation of the substitution pattern of the ligand.

Thus, a further embodiment of the invention is a display containing
- a W-OLED light source; and
- a color filter comprising a dye according to the invention.

The invention is further described by but not limited to the following examples.

### Example 1a:

A compound of the following formula (IV) was prepared according to the following procedure:
25 ml of concentrated hydrochloric acid were treated with 10.4 g (50 mmol) of 2-amino-5-nitro-benzotrifluoride (99%, available from Aldrich) and cooled to 0 °C. 11 ml (55 mmol) of 5N sodium nitrite solution was added drop-wise over a period of 30 minutes. After completion the excess of nitrite was destroyed by adding amidosulfonic acid. A mixture of 13.0 g (50 mmol) of 3-N,N-diethylamino trifluoroacetanilide dissolved in 40 ml of acetone was added drop-wise at about 0 to 5 °C while the pH of the mixture was maintained at 5-6 by parallel addition of 15% sodium hydroxide solution. After stirring for 15 minutes the mixture was filtered and the residue was washed with warm water until it was free of chlorides and dried under reduced pressure at 80 °C to provide the compound of formula (IV). 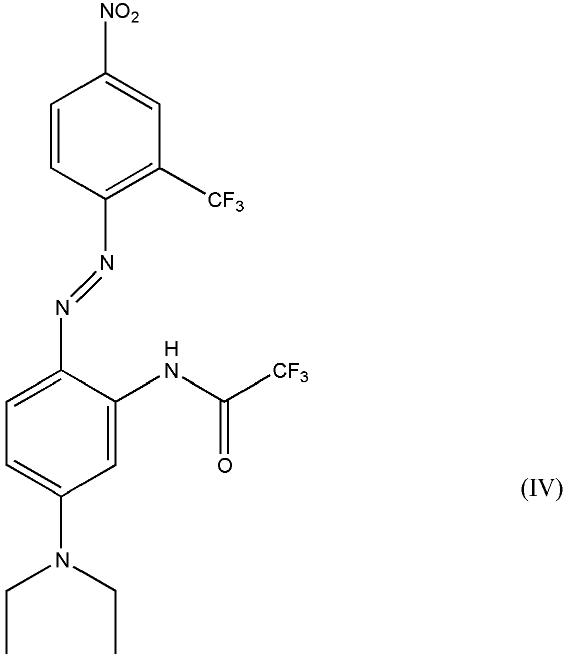
UV-VIS: ε at λₘₐₓ = 522 nm: 115 (L*cm⁻¹*g⁻¹, propylene glycole monomethylether acetate)

Solubility in propylene glycole monomethylether acetate: 2.5% (wt/wt).

### Example 1b:

In a second step the metal complex of the compound of Formula (IV) (Example 1a) was prepared. 1.0 g (2.1 mmol) of the compound of formula (IV) was dissolved in 10.0 g of dimethylformamide and 355 mg (3.2 mmol) of potassium tert-butoxide was added. The mixture was stirred for 30 minutes at room temperature (approximately 20 °C). Then 155 mg (1.1 mmol) of anhydrous zinc chloride were added and the mixture was stirred at 110 °C for a period of 7 hours. After the mixture was cooled down to approximately 20 °C 300 ml of water were added and again the mixture was stirred for 15 minutes. Subsequently the mixture was filtered and the residue was washed with 100 ml of warm water and dried under reduced pressure to yield the desired dye having a structure of formula (V). 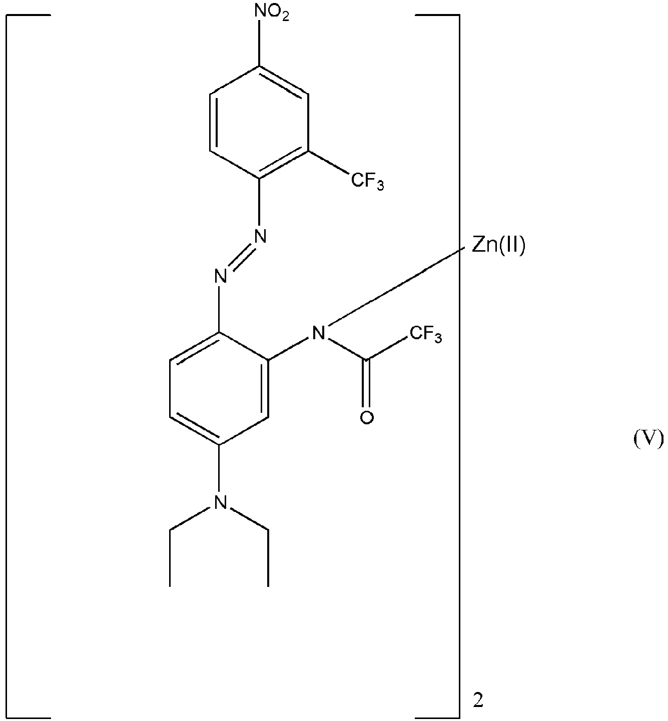 UV-VIS: ε at λₘₐₓ = 535 nm: 102 (L*cm⁻¹*g⁻¹, propylene glycole monomethylether acetate)
Solubility in propylene glycole monomethylether: 8% (wt/wt)

### Example 1c:

A mixture of the azo dye of Example 1a (1.0 g, 2.1 mmol), dimethylformamide (10.0g) and potassium tert-butylate (355 mg, 3.2 mmol) was stirred for 30 min at room temperature, treated with 135 mg (1.1 mmol) of anhydrous nickel chloride and heated for 3 h to 135 °C, after cooling to room temperature the mixture was treated with 1 g Celite, filtered and drowned in 100 ml of water, stirred for 15 min and filtered. The filter cake was washed with additional 100 ml of warm water and dried *in vaccuo* to obtain 610 mg (57%) of a dye of the following structure (VI): 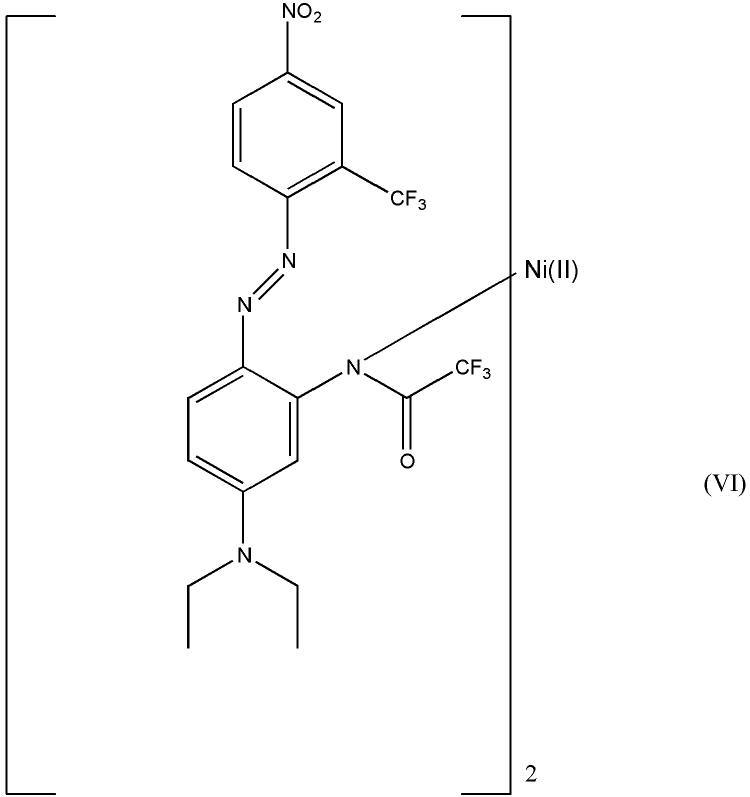 UV-VIS: ε at λₘₐₓ = 543 nm: 32 (L*cm⁻¹*g⁻¹, propylene glycole monomethylether acetate)
Solubility in propylene glycole monomethylether acetate: 1% (wt/wt)

### Example 2:

### Examble 2a: Azo coupling

A diazo solution was prepared in the following way: 5 ml of concentrated hydrochlorid acid was treated with 2.1 g (10 mmol) of 2-amino-5-nitrobenzotrifluoride (99%, Aldrich) and 5 ml acetone , cooled to 0 °C, and treated drop-wise with 2.2 ml (11 mmol) 5N sodium nitrite solution within 30 min. After completion the excess of nitrite was destroyed by adding amidosulfonic acid.

A mixture of 2.6 g (10 mmol) 3-*N,N*-diethylamino trifluoroacetanilide in 20 ml of acetone was treated drop-wise with the diazo solution prepared above at 0-5° C while the pH of the mixture was maintained at 5-7 by parallel addition of 15% sodium hydroxide solution. After stirring for 15 min, the mixture was evaporated to dryness at 60 °C *in vaccuo,* taken up in 50 ml acetone, salts were filtered off and the filtrate dried *in vaccuo* at 60° C to provide 3.1 g (65 %) of a dye of the following structure (VII): 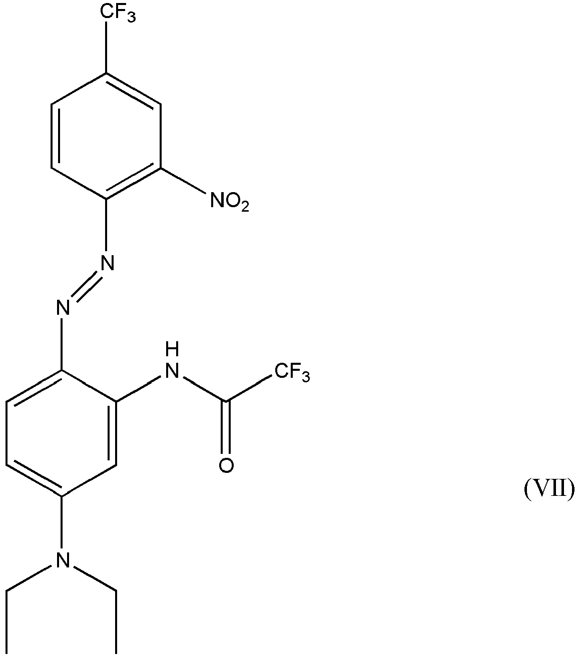 UV-VIS: ε at λₘₐₓ = 494 nm: 55 (L*cm⁻¹*g⁻¹, propylene glycole monomethylether acetate)
Solubility in propylene glycole monomethylether acetate: 2.5% (wt/wt)

### Example 2b: metal complex formation

A mixture of the azo dye of Example 2a (1.0 g, 2.1 mmol), dimethylformamide (10.0 g) and potassium tert-butylate (355 mg, 3.2 mmol) was stirred for 30 minutes at room temperature (20 °C), treated with 155 mg (1.1 mmol) of anhydrous zink chloride and heated for 7 h to 110 °C, after cooling to room temperature the mixture was drowned in 20 ml of water, stirred for 15 min and filtered. The filter cake was washed with additional 100 ml of warm water and dried *in vaccuo* to obtain 770 mg (69%) of a dye of the following structure (VIII): 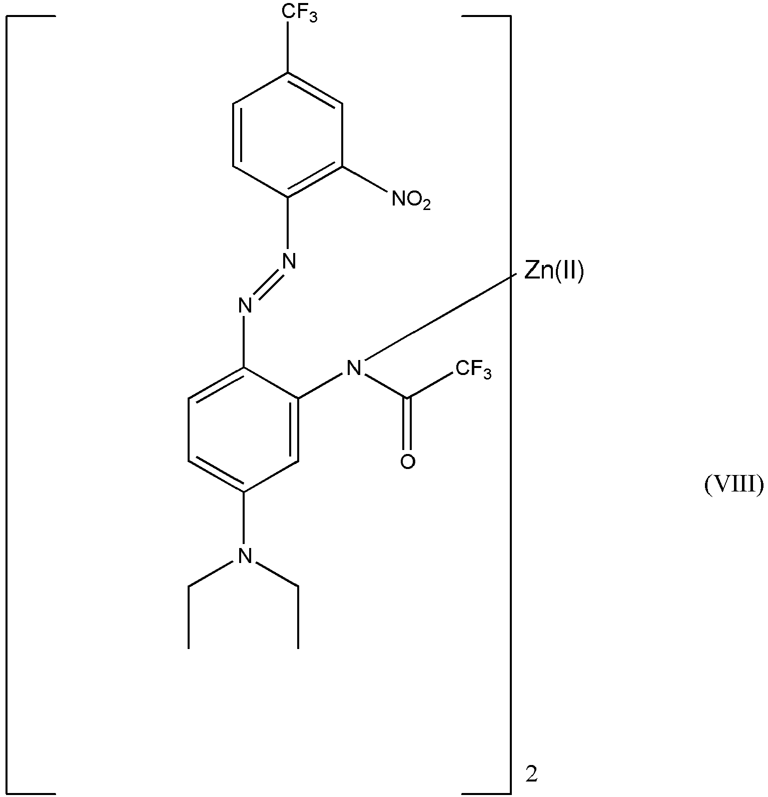 UV-VIS: ε at λₘₐₓ = 532 nm: 95 (L*cm⁻¹*g⁻¹, propylene glycole monomethylether acetate)
Solubility in propylene glycole monomethylether: 4% (wt/wt)

Examples 3a - 13a were prepared according to the procedure described for example 1a and are represented by the general structure

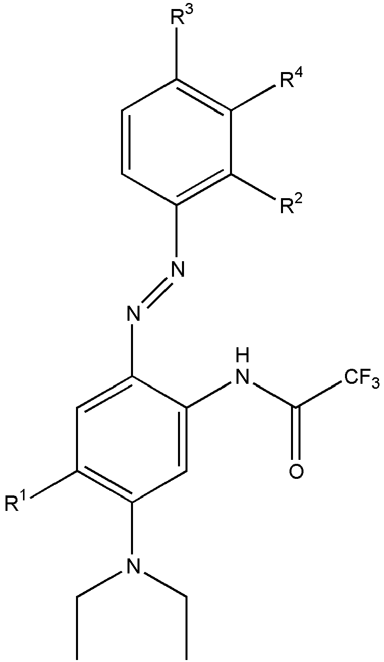

| Example | R¹ | R² | R³ | R⁴ | Yield (%) | UV-VIS (PGMEA, 0.001%): λₘₐₓ (nm) / ε (L*cm⁻¹*g⁻¹) |
|---|---|---|---|---|---|---|
| 3a | H | H | Cl | NO₂ | 43 | 489 /99 |
| 4a | H | NO₂ | isopropyl | NO₂ | 77 | 508 / 110 |
| 5a | OCH₃ | NO₂ | CF₃ | H | 69 | 522 / 63 |
| 6a | H | OCH₃ | NO₂ | H | 94 | 481 / 74 |
| 7a | H | CN | H | H | 54 | 484 / 41 |
| 8a | H | H | CN | H | 83 | 489 /131 |
| 9a | H | H | CN | CN | 58 | 508 / 33 |
| 10a | OCH₃ | NO₂ | isopropyl | NO₂ | 19 | 534 / 62 |
| 11a | OCH₃ | NO₂ | CF₃ | H | 91 | 511 / 14 |
| 12a | OCH₃ | CF₃ | NO₂ | H | 88 | 554 / 72 |
| 13a | OCH₃ | OCH₃ | NO₂ | H | 26 | 506 / 38 |

The metal complexes of examples 3b - 13b were prepared according to the procedure described for example 1b, for copper and nickel complexes, zink chloride was substituted by the same molecular amount of copper(II)chloride or nickel(II)chloride, respectively.

The metal complexes obtained are represented by the general structure:

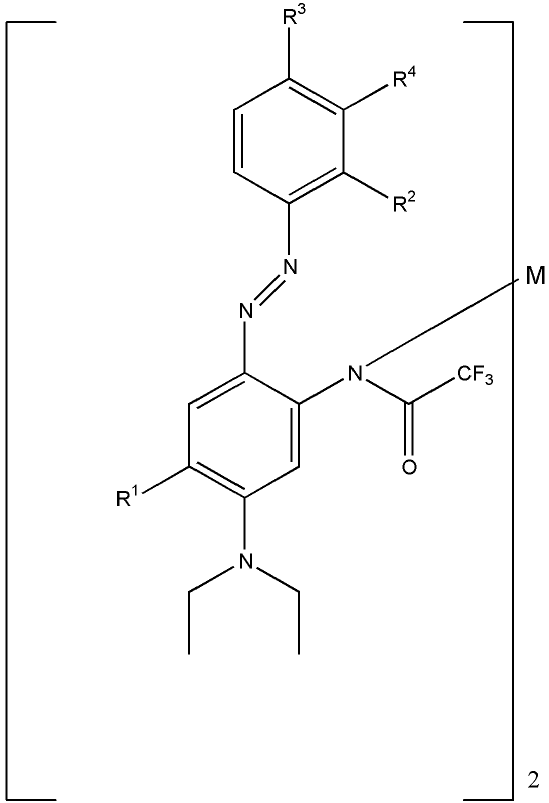

| Example | M | R¹ | R² | R³ | R⁴ | Yield (%) | Solubility (PGMEA, %) | UV-VIS (PGMEA, 0.001%): λₘₐₓ (nm) / ε (L*cm⁻¹*g⁻¹) |
|---|---|---|---|---|---|---|---|---|
| 3b | Zn | H | H | Cl | NO₂ | 43 | 2,5 | 513 / 78 |
| 4b | Zn | H | NO₂ | isopropyl | NO₂ | 64 | 1 | 511 / 92 |
| 5b | Zn | OCH₃ | NO₂ | CF₃ | H | 81 | 1 | 506 / 56 |
| 6b | Ni | H | OCH₃ | NO₂ | H | 56 | 5 | 512 / 67 |
| 7b | Zn | H | CN | H | H | 36 | 2,5 | 507 / 59 |
| 8b | Zn | H | H | CN | H | 48 | 1 | 513 /75 |
| 9b | Zn | H | H | CN | CN | 26 | 5 | 524 / 49 |
| 10b | Ni | OCH₃ | NO₂ | isopropyl | NO₂ | 69 | 5 | 536/36 |
| 11b | Cu | OCH₃ | NO₂ | CF₃ | H | 74 | 2,5 | 524 / 38 |
| 12b | Zn | OCH₃ | CF₃ | NO₂ | H | 68 | 1 | 562 / 55 |
| 13b | Zn | OCH₃ | OCH₃ | NO₂ | H | 85 | 5 | 516/42 |

### Application example

A curable dye composition according to the invention was prepared including the following components.
- the dye according to the invention;
- a methacrylic acid/benzylmethacrylate copolymer having a weight average molecular weight of 28,000, which is mixed in a weight ratio of 30:70;
- photoinitiator CGI-124 available from BASF SE (Irgacure OXE 01; CAS-No.: [253585-83-0],
   1-[4-(phenylthio)phenyl]-1,2-octanedione2-(O-benzoyloxime));
- Dipentaerythritolhexaacrylate
- Propylene glycol monomethyl ether acetate and ethyl 3-ethoxypropionate.

### Color filter

1.7 g of the photoinitiator is dissolved in 31.1 g of propylene glycol monomethyl ether acetate and 17.3 g of ethyl 3-ethoxypropionate as solvent. The solution is agitated for 2 hours at room temperature. Next, 3.9 g of the dye as prepared in example 1b, 3.5 g of the methacrylic acid/benzylmethacrylate copolymer, and 8.5 g of dipentaerythritolhexaacrylate are added thereto. The mixture is agitated for 2 hours at room temperature (20 °C). The mixture is agitated for 1 hour at room temperature. The solution is filtrated three times to remove impurities, yielding the curable dye composition according to the invention.

### Comparative Example

A curable dye composition is prepared according to the method described above, except 3.9 g of pigment red 254 were used instead of the dye of example 1b.

### Experimental Example

The curable dye composition according to the invention and the curable dye composition of the comparative example are coated on a 10*10 cm² glass substrate in a spin-coating method and then pre-baked at 90 °C for 3 minutes. The resulting product is cooled under air and then radiated by UV having a wavelength of 365 nm to an exposure amount of 100 mJ/cm², fabricating a thin film. After the radiation, the thin film is post-baked at 230 °C in a hot air drier for 30 minutes, preparing a cured thin film.

The color coordinate, luminance, and contrast ratio of the cured thin films of the color filters according to the invention and the comparative example are measured according to the following methods: (x and y) (CIE coordinates of chromaticity according to ISO 11664-1:2007) and brightness (Y): a colorimeter (MCPD 3000, Korea Otsuka Pharmaceutical Co., Ltd.) is used. The contrast ratio was determined by means of a contrast ratio measurement device (Tsubosaka Electronic Co. Ltd., CT-1, 20, 000:1).

Color filter example 1: x= 0.6539, y= 0.3176, Y= 17.96, contrast ratio = 22,436 (2.14 micrometer film thickness).

Comparative example 1: x= 0.6537, y= 0.3172, Y= 17.92, contrast ratio = 10,965 (2.05 micrometer film thickness).

As can be seen, the color filter comprising the dye according to the invention has a much higher contrast ratio (factor 2 better) at the same level of brightness.

The durability is evaluated by dipping the cured thin films (A) in a N-methylpyrrolidone (NMP) solvent at room temperature for 30 minutes, and (B) in a mixed solvent of N-methylpyrrolidone (NMP) and ethylethoxypropionate

(hereinafter referred to as "EEP") mixed in a volume ratio of 5:5 at 80 °C for 10 minutes. ΔEab* is obtained by calculating a color difference before and after treating each cured thin film sample. When a cured thin film sample has ΔEab* of 3 or less, the value is reliable. The smaller the ΔEab* is, the better the durability of the cured thin film.

The color filter according to the invention shows an improved durability (ΔEab*-0.2) in comparison to the conventional color filter (ΔEab* - 0.3), prepared according to the procedure described above.

## Claims

1. Dye consisting of a metal complex comprising a metal ion M and a deprotonated compound of formula (I): 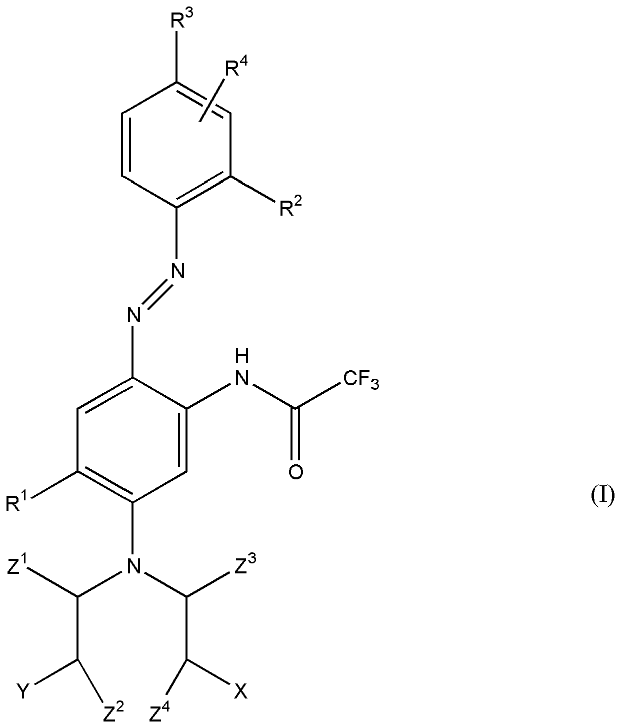 wherein
X is selected from the group consisting of -H, -OH, -OC₁₋₈-alkyl, -C₁₋₅-alkyl, -COOC₁₋₈-alkyl and -OC(O)R⁵;
Y is selected from the group consisting of -H, -OH, -OC₁₋₈-alkyl, -COOC₁₋₈ alkyl, -C₁₋₅-alkyl and -OC(O)R⁵;
Z¹, Z², Z³ and Z⁴ are independently selected from the group consisting of -H, methyl and phenyl;
R¹ is selected from the group consisting of -H, methyl and -OCH₃;
R² is selected from the group consisting of -H, -NO₂, -OC₁₋₈-alkyl, -CF₃, -COOC₁₋₈-alkyl, -CN, -F, -Cl and -Br;
R³ and R⁴ are independently selected from the group consisting of -H, -C₁₋₅-alkyl, -NO₂, -OC₁₋₈-alkyl, -CF₃, -COOC₁₋₈-alkyl, -CN, -F, -Cl and -Br; and
R⁵ is a branched or unbranched saturated carbon chain comprising 1 to 8 carbon atoms.

2. Dye according to claim 1 wherein M is a divalent ion selected from the group consisting of copper(II), nickel(II), zinc(II), iron(II) and cobalt(II).

3. Dye according to one or both of claims 1 and 2, wherein at least one of the substituents R² or R³ is -NO₂ or -CN.

4. Dye according to one or more of claims 1 to 3, wherein the dye is represented by formula (II) 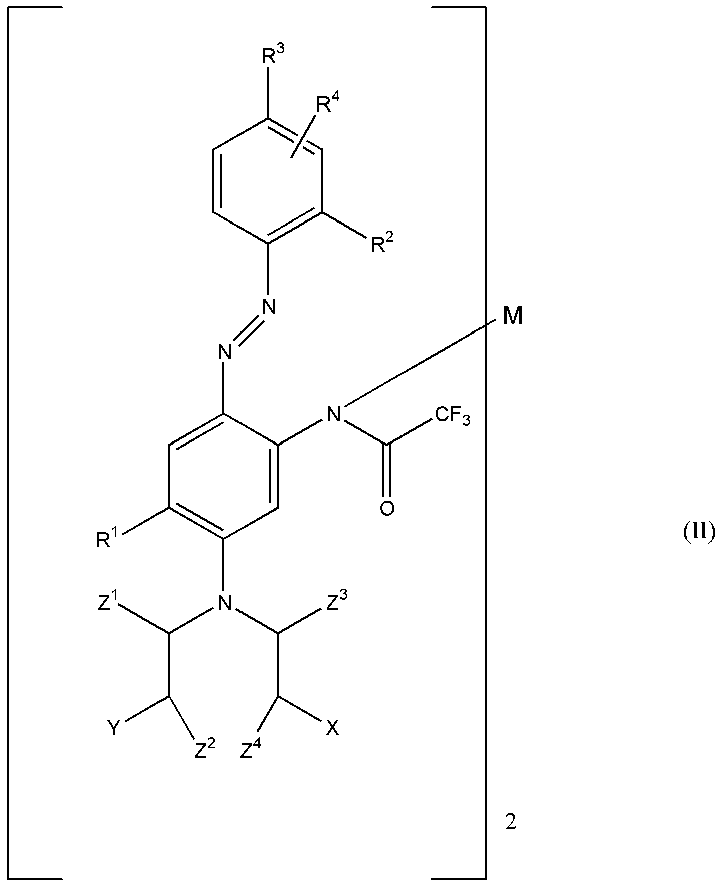 wherein
M is a divalent metal;
X is selected from the group consisting of -H, -OH, -OC₁₋₈-alkyl, -C₁₋₅-alkyl, -COOC₁₋₈-alkyl and -OC(O)R⁵;
Y is selected from the group consisting of -H, -OH, -OC₁₋₈-alkyl, -COOC₁₋₈-alkyl, -C₁₋₅-alkyl and -OC(O)R⁵;
Z¹, Z², Z³ and Z⁴ are independently selected from the group consisting of -H, methyl and phenyl;
R¹ is selected from the group consisting of -H, methyl and -OCH₃;
R² is selected from the group consisting of -H, -NO₂, -OC₁₋₈-alkyl, -CF₃, -COOC₁₋₈-alkyl, -CN, -F, -Cl and -Br;
R³ and R⁴ are independently selected from the group consisting of -H, -C₁₋₅-alkyl, -NO₂, -OC₁₋₈-alkyl, -CF₃, -COOC₁₋₈-alkyl, -CN, -F, -Cl and -Br; and
R⁵ is a branched or unbranched saturated carbon chain comprising 1 to 8 carbon atoms.

5. Dye according to one or more of claims 1 to 4 wherein the dye is represented by formula (III): 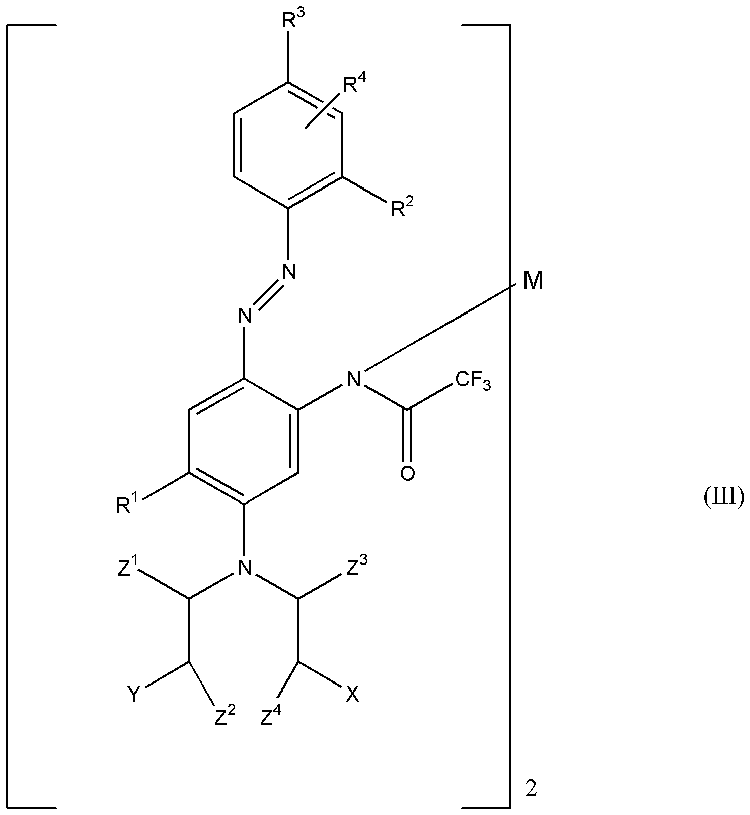 wherein
R¹ = H;
R² = -CN or -NO₂ or -CF₃;
R³ = -CN or -NO₂ or -H or -CF₃;
R⁴ = H or -NO₂ or -CN;
X = Y and selected from -H, -C₁₋₅-alkyl, -OH, -OC₁₋₈-alkyl, -OC(O)C₁₋₈-alkyl;
M = Fe or Zn or Ni; and
Z¹, Z², Z³ and Z⁴ are independently selected from H, methyl and phenyl with the provisio that
- if Z¹ is phenyl or methyl than Z² is H;
- if Z² is phenyl or methyl than Z¹ is H;
- if Z³ is phenyl or methyl than Z⁴ is H; and
- if Z⁴ is phenyl or methyl than Z³ is H.

6. Dye according to one or more of claims 1 to 5 for use in color filters.

7. Method for preparing a dye according to one or more of claims 1 to 6, involving the following steps:
a) Providing a compound of formula (I) 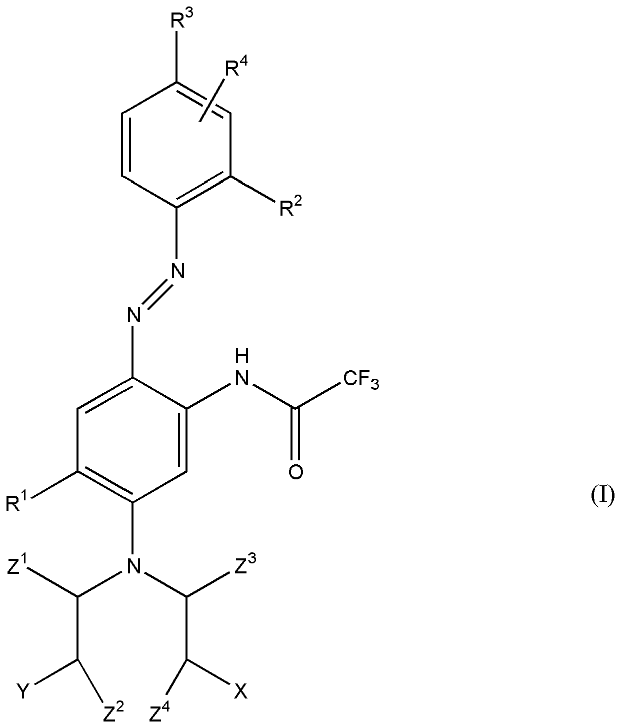 wherein
X is selected from the group consisting of -H, -OH, -OC₁₋₈-alkyl, -C₁₋₅-alkyl, -CO-C₁₋₈-alkyl and -OC(O)R⁵;
Y is selected from the group consisting of -H, -OH, -OC₁-C₈-alkyl, -COOC₁₋₈-alkyl, -C₁₋₅-alkyl and -OC(O)R⁵;
Z¹, Z², Z³ and Z⁴ are independently selected from the group consisting of -H, methyl and phenyl;
R¹ is selected from the group consisting of -H, methyl and -OCH₃;
R² is selected from the group consisting of -H, -NO₂, -OC₁₋₈-alkyl, -CF₃, -COOC₁₋₈-alkyl, -CN, -F, -Cl and -Br;
R³ and R⁴ are independently selected from the group consisting of -H, -C₁₋₅-alkyl, -NO₂, -OC₁₋₈-alkyl, -CF₃, -COOC₁₋₈-alkyl, -CN, -F, -Cl and -Br; and
R⁵ is a branched or unbranched saturated carbon chain comprising 1 to 8 carbon atoms;
b) Deprotonation of the compound of formula (I);
c) Addition of a metal ion M; and
d) Formation of a metal complex consisting of the compound of formula (I) and the metal ion M.

8. Method according to claim 7 wherein the preparation of the dye is carried out in the presence of a solvent, preferably an organic solvent selected from the group consisting of dimethylformamide (DMF), N-methylpyrrolidone (NMP), N,N-dimethylacetamide (DMAc) and dimethylsulfoxide (DMSO).

9. Method according to one or both of claims 7 and 8 wherein the deprotonation step b) is carried out by a base, preferably a metal alcoholate and/or a metal hydride selected from the group consisting of sodium hydride, potassium tert-butoxide, sodium tert-butoxide, potassium tert-amyloxide and sodium tert-amyloxide.

10. Curable dye composition comprising:
i) a dye according to one or more of claims 1 to 6;
ii) a radically polymerizable compound; and
iii) a photoinitiator.

11. Curable dye composition according claim 10 wherein the dye is dissolved in the radically polymerizable compound.

12. Curable dye composition according to one or both of claims 10 and 11 wherein the radically polymerizable compound is a (meth)acrylate.

13. Cured dye composition obtainable by curing a curable dye composition according to one or more of claims 10 to 12.

14. Use of a dye according to one or more of claims 1 to 6 or a curable dye composition according to one or more of claims 10 to 12 or a cured dye composition according to claim 13 for color filters.

15. Display containing
- a W-OLED light source and
- a color filter comprising a dye according to one or more of claims 1 to 6.

## Patentansprüche

1. Farbstoff, der aus einem Metallkomplex besteht, welcher ein Metallion M und eine deprotonierte Verbindung der Formel (I) umfasst: 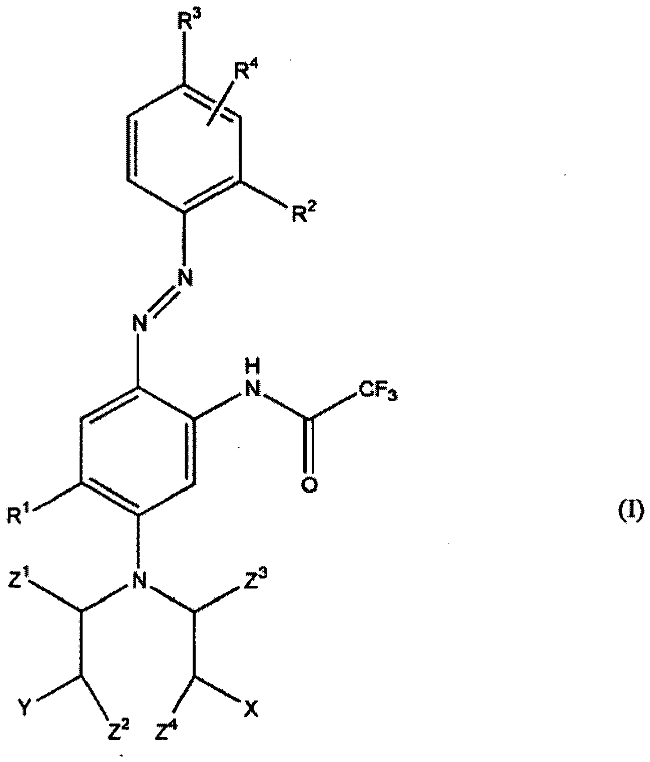 wobei
X aus der Gruppe ausgewählt ist, die aus -H, -OH, -O-C₁-₈-Alkyl, -C₁₋₅-Alkyl, -COO-C₁₋₈-Alkyl und -OC(O)R⁵ besteht;
Y aus der Gruppe ausgewählt ist, die aus -H, -OH, -O-C₁₋₈-Alkyl, -COO-C₁₋₈-Alkyl, -C₁₋₅-Alkyl und -OC(O)R⁵ besteht;
Z¹, Z², Z³ und Z⁴ unabhängig aus der Gruppe ausgewählt sind, die aus -H, Methyl und Phenyl besteht;
R¹ aus der Gruppe ausgewählt ist, die aus -H, Methyl und -OCH₃ besteht;
R² aus der Gruppe ausgewählt ist, die aus -H, -NO₂, -O-C₁₋₈-Alkyl, -CF₃, -COO-C₁₋₈-Alkyl, -CN, -F, -Cl und -Br besteht;
R³ und R⁴ unabhängig aus der Gruppe ausgewählt sind, die aus -H, -C₁₋₅-Alkyl, -NO₂, -O-C₁₋₈-Alkyl, -CF₃, -COO-C₁₋₈-Alkyl, -CN, -F, -Cl und -Br besteht;
R⁵ eine verzweigte oder unverzweigte gesättigte Kohlenstoffkette ist, die 1 bis 8 Kohlenstoffatome umfasst.

2. Farbstoff gemäß Anspruch 1, wobei M ein zweiwertiges Ion ist, das aus der Gruppe ausgewählt ist, die aus Kupfer(II), Nickel(II), Zink(II), Eisen(II) und Cobalt(II) besteht.

3. Farbstoff gemäß Anspruch 1 und/oder 2, wobei wenigstens einer der Substituenten R² oder R³ = -NO₂ oder -CN ist.

4. Farbstoff gemäß einem oder mehreren der Ansprüche 1 bis 3, wobei der Farbstoff durch Formel (II) dargestellt wird: 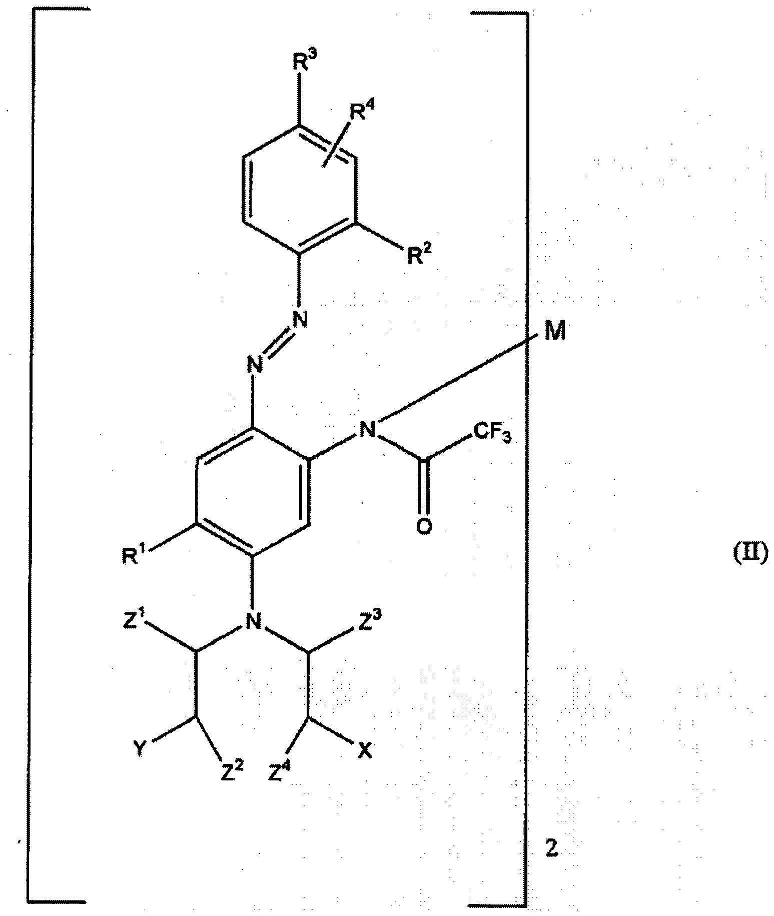 wobei
M ein zweiwertiges Metall ist;
X aus der Gruppe ausgewählt ist, die aus -H, -OH, -O-C₁₋₈-Alkyl, -C₁₋₅-Alkyl, -COO-C₁₋₈-Alkyl und -OC(O)R⁵ besteht;
Y aus der Gruppe ausgewählt ist, die aus -H, -OH, -O-C₁₋₈-Alkyl, -COO-C₁₋₈-Alkyl, -C₁₋₅-Alkyl und -OC(O)R⁵ besteht;
Z¹, Z², Z³ und Z⁴ unabhängig aus der Gruppe ausgewählt ist, die aus -H, Methyl und Phenyl besteht;
R¹ aus der Gruppe ausgewählt ist, die aus -H, Methyl und -OCH₃ besteht;
R² aus der Gruppe ausgewählt ist, die aus -H, -NO₂, -O-C₁₋₈-Alkyl, -CF₃, -COO-C₁₋₈-Alkyl, -CN, -F, -Cl und -Br besteht;
R³ und R⁴ unabhängig aus der Gruppe ausgewählt sind, die aus -H, -C₁₋₅-Alkyl, -NO₂, -O-C₁₋₈-Alkyl, -CF₃, -COO-C₁₋₈-Alkyl, -CN, -F, -Cl und -Br besteht;
R⁵ eine verzweigte oder unverzweigte gesättigte Kohlenstoffkette ist, die 1 bis 8 Kohlenstoffatome umfasst.

5. Farbstoff gemäß einem oder mehreren der Ansprüche 1 bis 4, wobei der Farbstoff durch Formel (III) dargestellt wird: 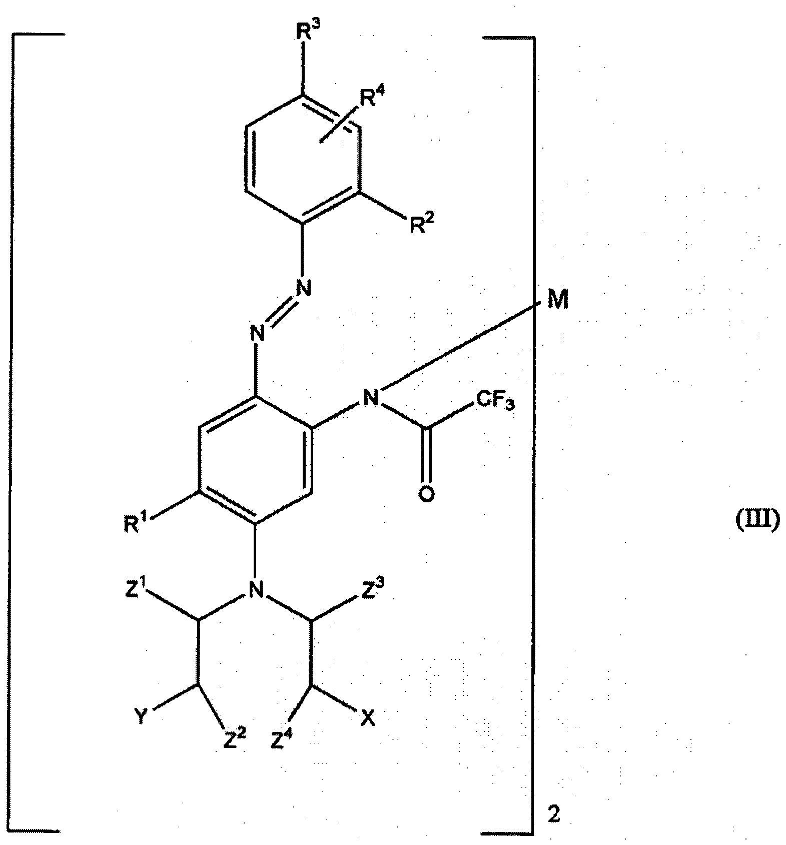 wobei
R¹ = H ist;
R² = -CN oder -NO₂ oder -CF₃ ist;
R³ = -CN oder -NO₂ oder -H oder -CF₃ ist;
R⁴ = H oder -NO₂ oder -CN ist;
X = Y ist und aus -H, -C₁₋₅-Alkyl, -OH, -O-C₁₋₈-Alkyl, -OC(O)-C₁₋₈-Alkyl ausgewählt ist;
M = Fe oder Zn oder Ni ist; und
Z¹, Z², Z³ und Z⁴ unabhängig aus H, Methyl und Phenyl ausgewählt sind, mit der Maßgabe, dass
- wenn Z¹ Phenyl oder Methyl ist, Z² = H ist;
- wenn Z² Phenyl oder Methyl ist, Z¹ = H ist;
- wenn Z³ Phenyl oder Methyl ist, Z⁴ = H ist; und
- wenn Z⁴ Phenyl oder Methyl ist, Z³ = H ist.

6. Farbstoff gemäß einem oder mehreren der Ansprüche 1 bis 5 zur Verwendung in Farbfiltern.

7. Verfahren zur Herstellung eines Farbstoffs gemäß einem oder mehreren der Ansprüche 1 bis 6, das die folgenden Schritte beinhaltet:
a) Bereitstellen einer Verbindung der Formel (I): 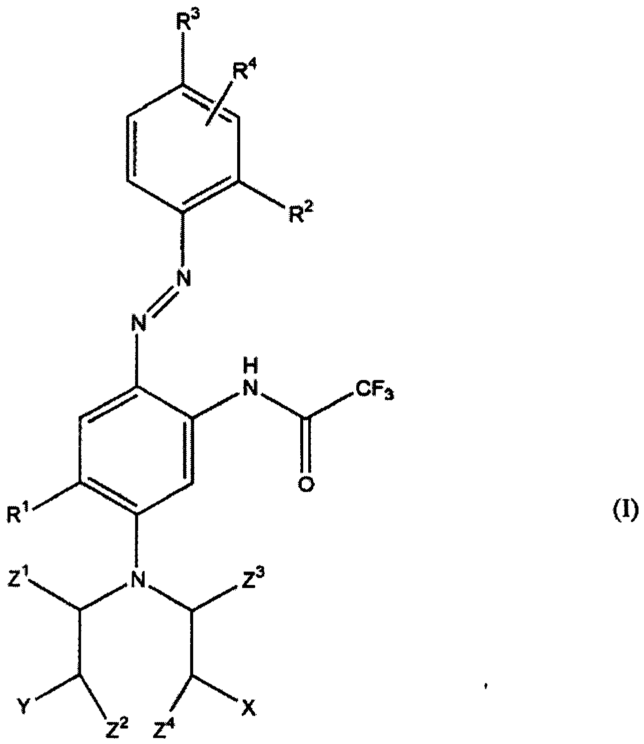 wobei
X aus der Gruppe ausgewählt ist, die aus -H, -OH, -O-C₁₋₈-Alkyl, -C₁₋₅-Alkyl, -COO-C₁₋₈-Alkyl und -OC(O)R⁵ besteht;
Y aus der Gruppe ausgewählt ist, die aus -H, -OH, -O-C₁₋₈-Alkyl, -COO-C₁₋₈-Alkyl, -C₁₋₅-Alkyl und -OC(O)R⁵ besteht;
Z¹, Z², Z³ und Z⁴ unabhängig aus der Gruppe ausgewählt sind, die aus -H, Methyl und Phenyl besteht;
R¹ aus der Gruppe ausgewählt ist, die aus -H, Methyl und -OCH₃ besteht;
R² aus der Gruppe ausgewählt ist, die aus -H, -NO₂, -O-C₁₋₈-Alkyl, -CF₃, -COO-C₁₋₈-Alkyl, -CN, -F, -Cl und -Br besteht;
R³ und R⁴ unabhängig aus der Gruppe ausgewählt sind, die aus -H, -C₁₋₅-Alkyl, -NO₂, -O-C₁₋₈-Alkyl, -CF₃, -COO-C₁₋₈-Alkyl, -CN, -F, -Cl und -Br besteht;
R⁵ eine verzweigte oder unverzweigte gesättigte Kohlenstoffkette ist, die 1 bis 8 Kohlenstoffatome umfasst;
b) Deprotonieren der Verbindung der Formel (I);
c) Zugabe eines Metallions M; und
d) Bildung eines Metallkomplexes, der aus der Verbindung der Formel (I) und dem Metallion M besteht.

8. Verfahren gemäß Anspruch 7, wobei die Herstellung des Farbstoffs in Gegenwart eines Lösungsmittels, vorzugsweise eines organischen Lösungsmittels, das aus der Gruppe ausgewählt ist, die aus Dimethylformamid (DMF), N-Methylpyrrolidon (NMP), N,N-Dimethylacetamid (DMAc) und Dimethylsulfoxid (DMSO) besteht, durchgeführt wird.

9. Verfahren gemäß Anspruch 7 und/oder 8, wobei der Deprotonierungsschritt b) durch eine Base, vorzugsweise ein Metallalkoholat und/oder ein Metallhydrid, das aus der Gruppe ausgewählt ist, die aus Natriumhydrid, Kalium-tert-butoxid, Natrium-tert-butoxid, Kalium-tert-amyloxid und Natrium-tert-amyloxid besteht, durchgeführt wird.

10. Härtbare Farbstoffzusammensetzung, umfassend:
i) einen Farbstoff gemäß einem oder mehreren der Ansprüche 1 bis 6;
ii) eine radikalisch polymerisierbare Verbindung; und
iii) einen Photoinitiator.

11. Härtbare Farbstoffzusammensetzung gemäß Anspruch 10, wobei der Farbstoff in der radikalisch polymerisierbaren Verbindung aufgelöst ist.

12. Härtbare Farbstoffzusammensetzung gemäß Anspruch 10 und/oder 11, wobei die radikalisch polymerisierbare Verbindung ein (Meth)acrylat ist.

13. Gehärtete Farbstoffzusammensetzung, erhältlich durch Härten einer härtbaren Farbstoffzusammensetzung gemäß einem oder mehreren der Ansprüche 10 bis 12.

14. Verwendung eines Farbstoffs gemäß einem oder mehreren der Ansprüche 1 bis 6 oder einer härtbaren Farbstoffzusammensetzung gemäß einem oder mehreren der Ansprüche 10 bis 12 oder einer gehärteten Farbstoffzusammensetzung gemäß Anspruch 13 für Farbfilter.

15. Anzeige, enthaltend
- eine W-OLED-Lichtquelle und
- einen Farbfilter, der einen Farbstoff gemäß einem oder mehreren der Ansprüche 1 bis 6 umfasst.

## Revendications

1. Colorant consistant en un complexe métallique comprenant un ion métallique M et un composé déprotoné répondant à la formule (I): 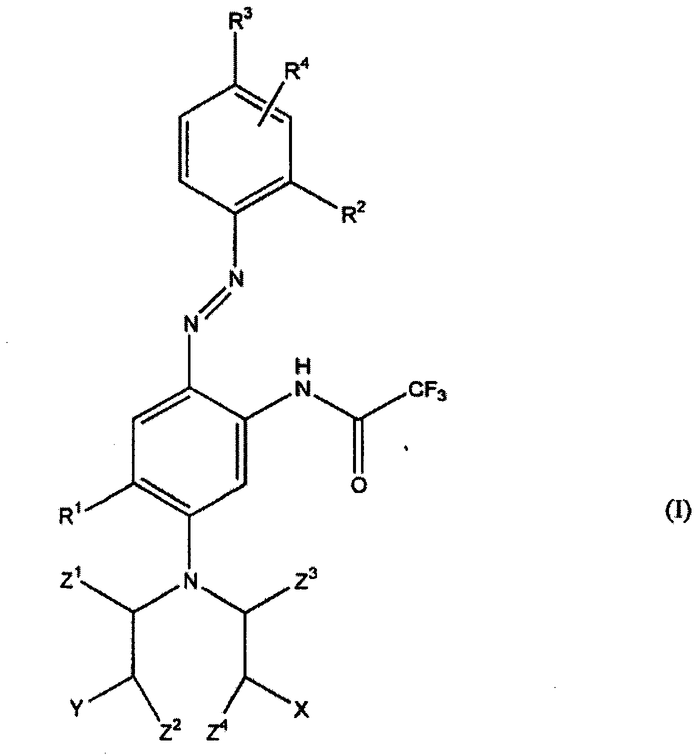 où
X est choisi dans le groupe consistant en -H, -OH, -O-C₁₋₈-alkyle, -C₁₋₅-alkyle, -COO-C₁₋₈-alkyle et -OC(O)R⁵;
Y est choisi dans le groupe consistant en -H, -OH, -O-C₁₋₈-alkyle, -COO-C₁₋₈-alkyle, -C₁₋₅-alkyle et -OC(O)R⁵;
Z¹, Z², Z³ et Z⁴ sont indépendamment choisis dans le groupe consistant en -H, méthyle et phényle;
R¹ est choisi dans le groupe consistant en -H, méthyle et -OCH₃;
R² est choisi dans le groupe consistant en -H, -NO₂, -O-C₁₋₈-alkyle, -CF₃, -COO-C₁₋₈-alkyle, -CN, -F, -CI et -Br;
R³ et R⁴ sont indépendamment choisis dans le groupe consistant en -H, -C₁₋₅-alkyle, -NO₂, -O-C₁₋₈-alkyle, -CF₃, -COO-C₁₋₈-alkyle, -CN, -F, -CI et -Br; et
R⁵ est une chaîne carbonée saturée ramifiée ou non-ramifiée, comprenant de 1 à 8 atomes de carbone.

2. Colorant selon la revendication 1, dans lequel M est un ion divalent choisi dans le groupe consistant en cuivre(II), nickel(II), zinc(II), fer(II) et cobalt(II).

3. Colorant selon l'une des revendications 1 et/ou 2, dans lequel au moins un des substituants R² ou R³ est -NO₂ ou -CN.

4. Colorant selon l'une quelconque des revendications 1 à 3, dans lequel le colorant est représenté par la formule (II) 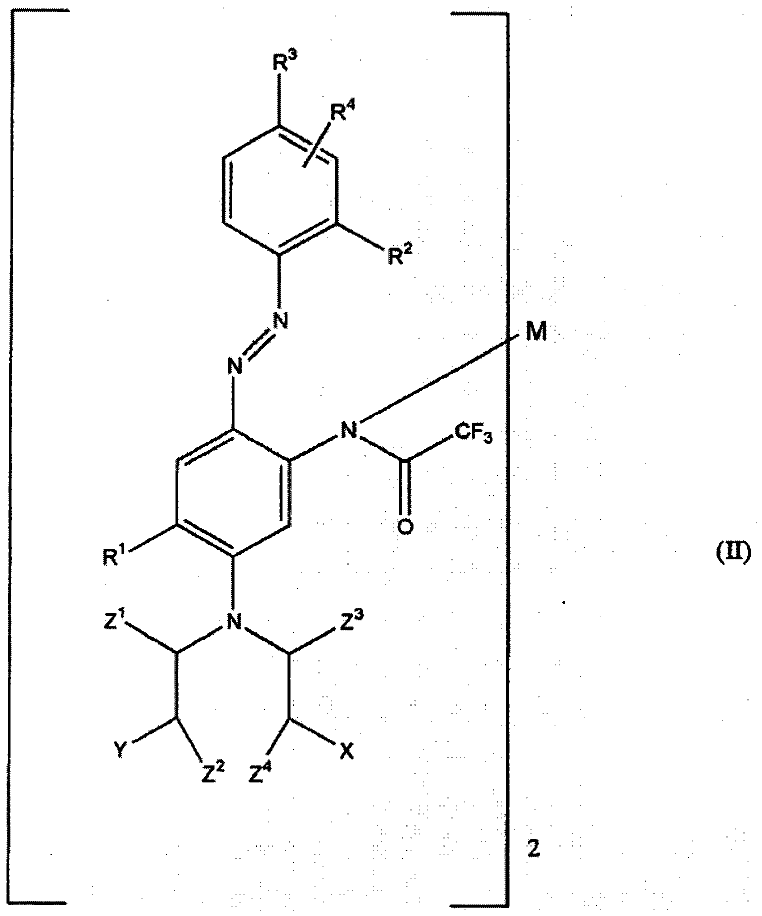 où
M est un métal divalent ;
X est choisi dans le groupe consistant en -H, -OH, -O-C₁₋₈-alkyle, -C₁₋₅-alkyle, -COO-C₁₋₈-alkyle et -OC(O)R⁵;
Y est choisi dans le groupe consistant en -H, -OH, -O-C₁₋₈-alkyle, -COO-C₁₋₈-alkyle, -C₁₋₅-alkyle et -OC(O)R⁵;
Z¹, Z², Z³ et Z⁴ sont indépendamment choisis dans le groupe consistant en -H, méthyle et phényle;
R¹ est choisi dans le groupe consistant en -H, méthyle et -OCH₃;
R² est choisi dans le groupe consistant en -H, -NO₂, -O-C₁₋₈-alkyle, -CF₃, -COO-C₁₋₈-alkyle, -CN, -F, -Cl et -Br;
R³ et R⁴ sont indépendamment choisis dans le groupe consistant en -H, -C₁₋₅-alkyle, -NO₂, -O-C₁₋₈-alkyle, -CF₃, -COO-C₁₋₈-alkyle, -CN, -F, -Cl et -Br; et
R⁵ est une chaîne carbonée saturée ramifiée ou non-ramifiée, comprenant de 1 à 8 atomes de carbone.

5. Colorant selon l'une quelconque des revendications 1 à 4, dans lequel le colorant est représenté par la formule (III) 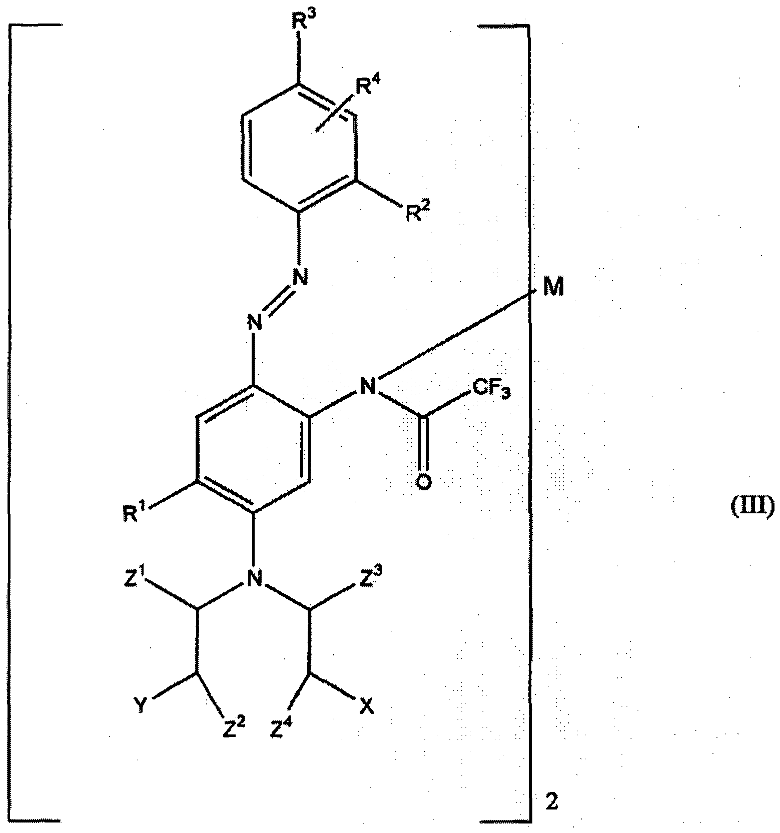 où
R¹ = H ;
R² = -CN ou -NO₂ ou -CF₃;
R³ = -CN ou -NO₂ ou -H ou -CF₃;
R⁴ = H ou -NO₂ ou -CN;
X = Y et est choisi parmi -H, -C₁₋₅-alkyle, -OH, -O-C₁₋₈-alkyle, -OC(O)-C₁₋₈-alkyle;
M = Fe ou Zn ou Ni; et
Z¹, Z², Z³ et Z⁴ sont indépendamment choisis parmi H, méthyle et phényle, à condition que
- lorsque Z¹ est phényle ou méthyle, Z² = H;
- lorsque Z² est phényle ou méthyle, Z¹ = H;
- lorsque Z³ est phényle ou méthyle, Z⁴ = H; et
- lorsque Z⁴ est phényle ou méthyle, Z³ = H.

6. Colorant selon l'une quelconque des revendications 1 à 5 pour être utilisé dans des filtres couleur.

7. Procédé pour préparer un colorant selon l'une quelconque des revendications 1 à 6, comprenant les étapes suivantes consistant à:
a) procurer un composé de la formule (I) 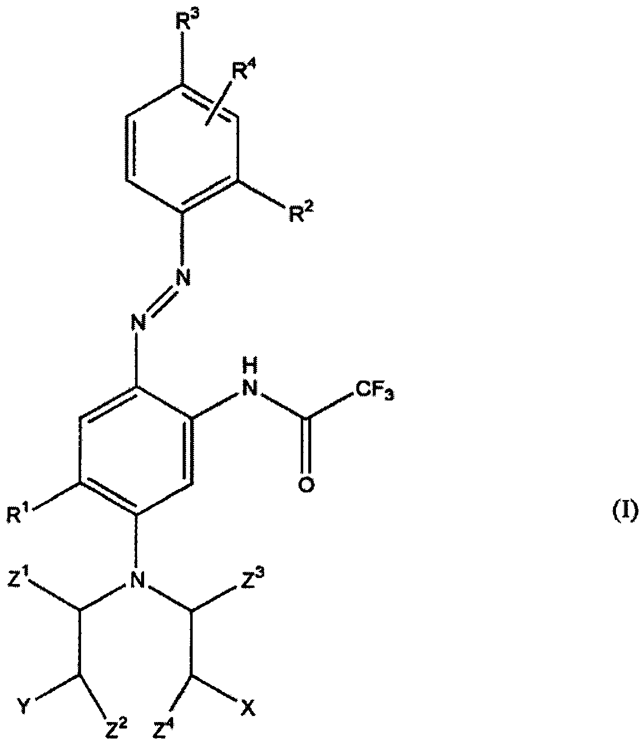 où
X est choisi dans le groupe consistant en -H, -OH, -O-C₁₋₈-alkyle, -C₁₋₅-alkyle, -COO-C₁₋₈-alkyle et -OC(O)R⁵;
Y est choisi dans le groupe consistant en -H, -OH, -O-C₁₋₈-alkyle, -COO-C₁₋₈-alkyle, -C₁₋₅-alkyle et -OC(O)R⁵;
Z¹, Z², Z³ et Z⁴ sont indépendamment choisis dans le groupe consistant en -H, méthyle et phényle;
R¹ est choisi dans le groupe consistant en -H, méthyle et -OCH₃;
R² est choisi dans le groupe consistant en -H, -NO₂, -O-C₁₋₈-alkyle, -CF₃, -COO-C₁₋₈-alkyle, -CN, -F, -CI et -Br;
R³ et R⁴ sont indépendamment choisis dans le groupe consistant en -H, -C₁₋₅-alkyle, -NO₂, -O-C₁₋₈-alkyle, -CF₃, -COO-C₁₋₈-alkyle, -CN, -F, -Cl et -Br; et
R⁵ est une chaîne carbonée saturée ramifiée ou non-ramifiée, comprenant de 1 à 8 atomes de carbone;
b) déprotoner le composé de la formule (I);
c) ajouter un ion métallique M; et
d) former un complexe métallique consistant en le composé de la formule (I) et l'ion métallique M.

8. Procédé selon la revendication 7, dans lequel la préparation du colorant est exécutée en la présence d'un solvant, de préférence d'un solvant organique choisi dans le groupe consistant en le diméthylformamide (DMF), le N-méthylpyrrolidone (NMP), le N,N-diméthylacétamide (DMAc), et le diméthylsulfoxide (DMSO).

9. Procédé selon l'une des revendications 7 et/ou 8, dans lequel l'étape de déprotonation b) est exécutée par une base, de préférence un alcoolate métallique et/ou un hydrure métallique choisi dans le groupe consistant en l'hydride de sodium, le tert-butoxyde de potassium, le tert-butoxyde de sodium, le tert-amyloxide de potassium, et le tert-amyloxide de sodium.

10. Composition de colorant durcissable, comprenant:
i) un colorant selon l'une quelconque des revendications 1 à 6;
ii) un composé polymérisable par voie radicalaire; et
iii) un photo-initiateur.

11. Composition de colorant durcissable selon la revendication 10, dans lequel le colorant est dissout dans le composé polymérisable par voie radicalaire.

12. Composition de colorant durcissable selon l'une des revendications 10 et/ou 11, dans laquelle le composé polymérisable par voie radicalaire est le (méth)acrylate.

13. Composition de colorant durcie, obtenable par le durcissement d'une composition de colorant durcissable selon l'une quelconque des revendications 10 à 12.

14. Utilisation d'un colorant selon l'une quelconque des revendications 1 à 6 ou d'une composition de colorant durcissable selon l'une quelconque des revendications 10 à 12, ou d'une composition de colorant durcie selon la revendication 13 pour des filtres couleur.

15. Affichage, contenant
- une source de lumière W-OLED, et
- un filtre de couleur comprenant un colorant selon l'une quelconque des revendications 1 à 6.
